# EUROPEAN PATENT APPLICATION

(11) **EP 2 685 536 A1**
(43) Date of publication of application: **15.01.2014**
(21) Application number: 13188261.5
(22) Date of filing: 14.08.2009
(51) Int. Cl.: H01M 4/88, H01M 4/04, H01M 4/1393, H01G 11/26, H01M 4/133, H01M 4/583, H01G 11/36, H01M 4/86, H01M 4/36, H01M 4/92

(54) **Layer-by-layer assemblies of carbon-based nanostructures and their applications in energy storage and generation devices**

(30) Priority: 15.08.2008 US 89406 P
(62) Divisional of application: 09789146.9
(71) Applicant: Massachusetts Institute of Technology, Cambridge, MA 02139 (US)
(72) Inventor: Shao-Horn, Yang, Cambridge, MA 02138 (US); Lee, Seung Woo, Cambridge, MA 02139 (US); Yabuuchi, Naoaki, Cambridge, MA 02139 (US); Hammond-Cunningham, Paula T., Newton, MA 02459 (US)
(74) Representative: HOFFMANN EITLE

(57) **Abstract**

The present invention relates to an electrode with a thickness of at least about 10 nanometers comprising carbon-based nanostructures, and defining a composition volume, wherein: each of the carbon-based nanostructures defines a nanostructure volume, the total of the volumes of the nanostructures defines at least about 60% of the composition volume, and at least a portion of the carbon-based nanostructures comprise carbon-oxygen bonds wherein oxygen defines at least about 10% of the mass of the solids in the composition.

## Description

### RELATED APPLICATIONS

This application claims the benefit of U.S. Provisional Patent Application Serial No. 61/089,406, filed August 15, 2008, entitled "Layer-By-Layer Assemblies of Carbon-Based Nanostructures and their Applications in Energy Storage and Generation Devices," by Shao-Horn, *et al.,* the entirety of which is incorporated herein by reference.

### FIELD OF INVENTION

The invention relates generally to carbon-based nanostructures and, more particularly, to methods and devices associated with layer-by-layer assembly and/or functionalization of carbon-based nanostructures.

### BACKGROUND

As the sustainability of traditional energy sources and storage methods has come into question, recent research has focused on the development of novel energy conversion and storage devices. Carbon-based nanostructures such as graphite, carbon nanotubes, and fullerenes have attracted attention in this field due to their unique mechanical and electronic properties. For example, carbon nanotubes can exhibit high electron mobility, making them potentially useful in fabricating the electrodes of various energy conversion devices (e.g., photovoltaic cells, fuel cells, batteries, and supercapacitors, among others). Carbon-based nanostructures possess several physical properties that may be desirable for such applications including high electrical conductivity, superior chemical and mechanical stability, and large surface area. However, due to strong van der Waals interaction between carbon-based nanostructures, the precipitation of carbon-based nanostructures from solution can be difficult to control and often results in the formation of poorly-performing structures.

Accordingly, improved methods are needed.

### SUMMARY OF INVENTION

The present invention relates generally to compositions and methods for layer-by-layer assembly and/or functionalization of carbon-based nanostructures. The subject matter of the present invention involves, in some cases, interrelated products, alternative solutions to a particular problem, and/or a plurality of different uses of one or more systems and/or articles.

In one aspect, the invention is directed to a method. In one set of embodiments, the method comprises providing a first fluid containing carbon-based nanostructures, the carbon-based nanostructures in the first fluid comprising positively-charged functional groups; providing a second fluid containing carbon-based nanostructures, the carbon-based nanostructures in the second fluid comprising negatively-charged functional groups; exposing a first portion of a surface of a substrate to the first fluid and depositing, proximate the first substrate surface portion, a first set of carbon-based nanostructures; and separately exposing a second portion of a surface of the substrate, which can be the same or different from the first substrate surface portion, to the second fluid and depositing, proximate the second substrate surface portion, a second set of carbon-based nanostructures.

In one set of embodiments, the method comprises using a device comprising an electrode comprising carbon-based nanostructures to achieve a capacitance at the electrode of at least about 300 Farads per cubic centimeter of the electrode. In one set of embodiments, the method comprises using a device comprising an electrode comprising carbon-based nanostructures to achieve an energy density at the electrode of at least about 400 Watt-hours per liter of the electrode. In one set of embodiments, the method comprises using a device comprising an electrode comprising carbon-based nanostructures to achieve a capacitance at the electrode of at least about 400 Farads per gram of the electrode. In one set of embodiments, the method comprises using a device comprising an electrode comprising carbon-based nanostructures to achieve a specific energy at the electrode of at least about 500 Watt-hours per kilogram of the electrode.

In one aspect, the invention is directed to a composition. In one set of embodiments, the composition comprises an electrode with a thickness of at least about 10 nanometers comprising carbon-based nanostructures and defining a composition volume, each of the carbon-based nanostructures defining a nanostructure volume, wherein the total of the volumes of the nanostructures defines at least about 60% of the composition volume.

In one aspect, the invention is directed to a device. In one set of embodiments, the device comprises an electrode comprising carbon-based nanostructures capable of achieving a capacitance at the electrode of at least about 300 Farads per cubic centimeter of the electrode. In one set of embodiments, the device comprises an electrode comprising carbon-based nanostructures capable of achieving an energy density at the electrode of at least about 400 Watt-hours per liter of the electrode. In one set of embodiments, the device comprises an electrode comprising carbon-based nanostructures capable of achieving a capacitance at the electrode of at least about 400 Farads per gram of the electrode. In one set of embodiments, the device comprises an electrode comprising carbon-based nanostructures capable of achieving a specific energy at the electrode of at least about 500 Watt-hours per kilogram of the electrode. In one set of embodiments, the device comprises an electrode capable of converting at least about 60% of energy input into the device during a charging step to energy stored within the device, the charging step performed so as to charge the device to a capacity of at least 50% within 1 second. In one set of embodiments, the device comprises an electrode capable of converting at least about 60% of the energy stored after a charging step to electricity during a discharge step, the discharge step performed such that at least 50% of the capacity of the device is discharged within 1 second. In one set of embodiments, the device comprises an electrode capable of converting at least about 60% of energy input into the device during a charging step to energy stored within the device, the charging step performed at a rate of at least about 1 kW per kilogram of the electrode. In one set of embodiments, the device comprises an electrode capable of converting at least about 60% of the energy stored after a charging step to electricity during a discharge step, the discharge step performed at a rate of at least about 1 kW per kilogram of the electrode.

Other aspects, embodiments and features of the invention will become apparent from the following detailed description when considered in conjunction with the accompanying drawings. The accompanying figures are schematic and are not intended to be drawn to scale. For purposes of clarity, not every component is labeled in every figure, nor is every component of each embodiment of the invention shown where illustration is not necessary to allow those of ordinary skill in the art to understand the invention. All patent applications and patents incorporated herein by reference are incorporated by reference in their entirety. In case of conflict, the present specification, including definitions, will control.

### BRIEF DESCRIPTION OF THE DRAWINGS

Non-limiting embodiments of the present invention will be described by way of example with reference to the accompanying figures, which are schematic and are not intended to be drawn to scale. In the figures, each identical or nearly identical component illustrated is typically represented by a single numeral. For purposes of clarity, not every component is labeled in every figure, nor is every component of each embodiment of the invention shown where illustration is not necessary to allow those of ordinary skill in the art to understand the invention. In the figures:
FIGS. 1A-1E include schematic diagrams of a method of making an assembly of carbon-based nanostructures, according to one set of embodiments;
FIGS. 2A-2D include (A) X-ray photoelectron spectroscopy (XPS) spectra of functionalized MWNTs, (B) O₁ₛ regions of MWNT-COOH (2 hr oxidation), (C) cyclic voltammogram data of an LBL-MWNT electrode before and after 500 °C H₂-treatment; and (D) XPS C 1s spectra of an LBL-MWNT electrode before and after 500 °C H₂-treatment, according to one set of embodiments;
FIGS. 3A-3B include photographs of carbon-based nanostructures suspended in solution according to one set of embodiments;
FIGS. 4A-4C include (A) plots of the thicknesses of films of carbon-based nanostructures against the number of bi-layers, (B) zeta potential as a function of pH, and (C) plots of the thicknesses of films of carbon-based nanostructures against the number of bi-layers according to one set of embodiments;
FIG. 5 includes a photograph of various carbon-based nanostructure films, according to one set of embodiments;
FIGS. 6A-6B include atomic force microscopy (AFM) height images of assemblies of carbon-based nanostructures deposited at different pH conditions, according to one set of embodiments;
FIGS. 7A-7C include scanning electron microscopy (SEM) images of assemblies of carbon-based nanostructures, according to one set of embodiments;
FIGS. 8A-8F include photographs of assemblies of carbon-based nanostructures, according to one set of embodiments;
FIG. 9 includes XPS spectra of the N₁ₛ region of an assembly of carbon-based nanostructures, according to one set of embodiments;
FIG. 10 includes a plot of sheet resistance as a function of number of bi-layers for assemblies of carbon-based nanostructures, according to one set of embodiments;
FIG. 11 includes a cyclic voltammogram for assemblies of carbon-based nanostructures according to one set of embodiments;
FIG. 12 includes a plot of integrated charge as a function of the film thickness for assemblies of carbon-based nanostructures, according to one set of embodiments;
FIG. 13 includes a TEM micrograph of Pt on a surface of an assembly of carbon-based nanostructures, according to one set of embodiments;
FIG. 14 includes a TEM micrograph of Pt on a surface of an assembly of carbon-based nanostructures, according to one set of embodiments;
FIG. 15 includes plots of thickness and transmittance as a function of the number of bilayers, according to one set of embodiments;
FIG. 16 includes a plot of mass as a function of thickness, according to one set of embodiments;
FIG. 17 includes a schematic diagram outlining the electrochemical testing setup, according to one set of embodiments;
FIGS. 18A-18D include plots of device performance; according to one set of embodiments;
FIGS. 19A-19B include O1s and N1s spectra, according to one set of embodiments;
FIG. 20 includes a table outlining the composition of an exemplary electrode, according to one set of embodiments;
FIG. 21 includes an HRTEM image of an electrode, according to one set of embodiments;
FIGS. 22A-22D include plots of device performance, according to one set of embodiments;
FIG. 23 includes a plot of capacity retention as a function of C-rate, according to one set of embodiments;
FIG. 24 is a plot of specific energy as a function of specific power, according to one set of embodiments;
FIG. 25 includes an exemplary plot of thickness as a function of the number of bilayers;
FIGS. 26A-26B include plots of various performance parameters over multiple cycles of electrochemical cells, according to one set of embodiments;
FIGS. 27A-27B include plots of charge and discharge voltages as a function of specific current densities, according to one set of embodiments;
FIGS. 28A-28B include Ragone plots obtained for various thicknesses of LBL electrodes, according to one set of embodiments; and
FIGS. 29A-29C include plots of (A and B) charge and discharge voltages as a function of specific current densities and (C) specific current density as a function of charge cycles, according to one set of embodiments in which LTO counter-electrodes were employed.

### DETAILED DESCRIPTION

The embodiments described herein relate generally to methods, compositions, articles, and devices associated with layer-by-layer assembly and/or functionalization of carbon-based nanostructures and related structures. In some embodiments, the present invention provides methods for forming an assembly of carbon-based nanostructures on a surface. The carbon-based nanostructure assembly may exhibit enhanced properties, such as improved arrangement of carbon-based nanostructures (e.g., carbon nanotubes) and/or enhanced electronic and/or ionic conductivity and/or other useful features. In some cases, improved properties may be observed due, at least in part, to the attachment of functional groups to the surfaces of carbon-based nanostructures. Using methods described herein, formation of carbon-based nanostructure assemblies may be controlled to produced structures with enhanced properties.

The embodiments described herein may also involve devices capable of exhibiting enhanced properties. For example, the devices described herein may be capable of achieving high capacitance (per unit volume and/or mass), high energy density, and/or high specific energy. Carbon-based nanostructure assemblies of the invention may comprise features and/or components which may improve the ability of the assemblies to conduct electrons while maintaining the ability of the assemblies to conduct ions. Assemblies of carbon-based nanostructures as described herein may be useful in various devices, for example, in sensors, transistors, photovoltaic devices (e.g., photovoltaic cells), electrodes, semiconductors, high strength polymer materials, transparent conductors, barrier materials, energy storage devices (e.g., capacitors), and energy production devices (e.g., photovoltaic devices, fuel cells, electrochemical cells, etc.). The devices may be used in a variety of applications, including high-power applications such as power tools and hybrid vehicles.

Some embodiments described herein advantageously provide methods for processing carbon-based nanostructures that allow for the facile deposition, relative to previous methods, of thin films. In some embodiments, one may reduce the level of precipitation or agglomeration of carbon-based nanostructures in solution, compared to previous methods. Not wishing to be bound by any theory, it is believed that carbon-based nanostructures with similar charges within a fluid repel each other before a significant amount of agglomeration can occur over a time scale of interest. The ability to deposit carbon-based nanostructures in such a way may lead, in some cases, to improved performance in devices which incorporate assemblies of carbon-based nanostructures.

As used herein, the term "layer-by-layer" (LBL) assembly refers to a thin-film fabrication technique for forming a multi-layered structure, wherein the technique involves repeated, sequential exposure of one or more portions of a surface of a substrate to one or more fluids (e.g., solutions), each fluid containing a material to be formed on the substrate. Typically, this process results in the production of conformal thin films on a portion of the substrate surface. In some cases, one or more portions of a surface of a substrate may be exposed, in an alternating manner, to fluids (e.g., aqueous solutions) containing complementarily functionalized materials, thereby forming a multi-layered structure having alternating layers of complementarily functionalized materials. LBL assembly techniques enable the creation of ultrathin, highly-tunable functional films comprising various nanomaterials.

In one aspect, a method of forming an assembly of carbon-based nanostructures is described. As used herein, a "carbon-based nanostructure" comprises a structure which comprses at least about 30% carbon by mass, and which includes structures having an average maximum cross-sectional dimension of no more than about 1000 nm. In some embodiments, the carbon-based nanostructures may comprise at least about 40%, at least about 50%, at least about 60%, at least about 70%, at least about 80%, at least about 90%, or at least about 95% of carbon by mass, or more. As used herein, the "maximum cross-sectional dimension" refers to the largest distance between two opposed boundaries of an individual structure that may be measured. In one set of embodiements, the carbon-based nanostructures are particles, rods, tubes, or the like having a network of at least 5 aromatic rings of carbon atoms. These fused-ring carbon-based nanostructures may typically comprise a fused network of rings, such as aromatic rings. In some embodiments, the carbon-based nanostructure comprises a fused network of at least 10, at least 20, at least 30, at least 40, or, in some cases, at least 50 aromatic rings. The carbon-based nanostructure may be substantially planar or substantially non-planar, or may comprise a planar or non-planar portion. The carbon-based nanostructure may optionally comprise a border at which the fused network terminates. For example, a sheet of graphite is a planar carbon-containing molecule comprising a border at which the fused network terminates, while a fullerene is a nonplanar carbon-based nanostructure which lacks such a border. In some cases, the border may be substituted with hydrogen atoms. In some cases, the border may be substituted with groups comprising oxygen atoms (e.g., hydroxyl). In other cases, the border may be substituted as described herein. The term "fused network" might not include, for example, a biphenyl group, wherein two phenyl rings are joined by a single bond and are not fused. In some cases, the fused network may substantially comprise carbon atoms. In some cases, the fused network may comprise carbon atoms and heteroatoms. Some examples of carbon-based nanostructures include graphene, carbon nanotubes (e.g., singie-walled carbon nanotubes (SWNTs), multi-walled carbon nanotubes (MWNTs)), fullerenes, and the like.

In some cases, the carbon-based nanostructure may comprise an elongated chemical structure having a diameter on the order of nanometers and a length on the order of microns (e.g., tens of microns, hundreds of microns, etc.), resulting in an aspect ratio greater than 10, 100, 1000, 10,000, or greater. In some cases, the nanostructure may have a diameter less than 1 µm, less than 100 nm, 50 nm, less than 25 nm, less than 10 nm, or, in some cases, less than 1 nm. For example, the carbon-based nanostructure may have a cylindrical or pseudo-cylindrical shape, such as a carbon nanotube.

As used herein, the term "assembly of carbon-based nanostructures" refers to a plurality of interconnected carbon-based nanostructures. In some cases, the carbon-based nanostructures may be interconnected via bonds, including, for example, covalent bonds (e.g. carbon-carbon, carbon-oxygen, oxygen-silicon, sulfur-sulfur, phosphorus-nitrogen, carbon-nitrogen, metal-oxygen or other covalent bonds), ionic bonds, hydrogen bonds (e.g., between hydroxyl, amine, carboxyl, thiol and/or similar functional groups, for example), dative bonds (e.g. complexation or chelation between metal ions and monodentate or multidentate ligands), or the like. The interaction may also comprise, in some instances, Van der Waals interactions or a binding event between pairs of molecules, such as biological molecules, for example. In some embodiments, no more than about 2%, no more than about 5%, no more than about 10%, or no more than about 20% of the carbon-based nanostructures may comprise entities other than carbon, functional groups covalently bound to carbon, and/or ions ionically bound to carbon.

In one set of embodiments, assemblies of carbon-based nanostructures are formed by exposing a first portion of a surface of a substrate to a first fluid containing charged carbon-based nanostructures (resulting in the deposition, proximate the first substrate surface portion, of a first set of carbon-based nanostructures) and separately exposing a second portion of a surface of a substrate, which can be the same or different from the first substrate surface portion, to a second fluid containing oppositely-charged carbon-based nanostructures (resulting in the deposition, proximate the second substrate surface portion, of a second set of carbon-based nanostructures). As used herein, the term separately means that the portions of a surface of the substrate are exposed to different fluids (e.g., a first fluid, a second fluid, etc.) at different times. For example, a first portion of a surface of a substrate may be exposed to a first fluid, removed from contact with the first such that it is also not in contact with the second fluid, and subsequently a second portion may be exposed to a second fluid. As another example, a first fluid and a second fluid may be flowed across the surface of a substrate sequentially (e.g., as a continuous process) without substantial mixing between the fluids.

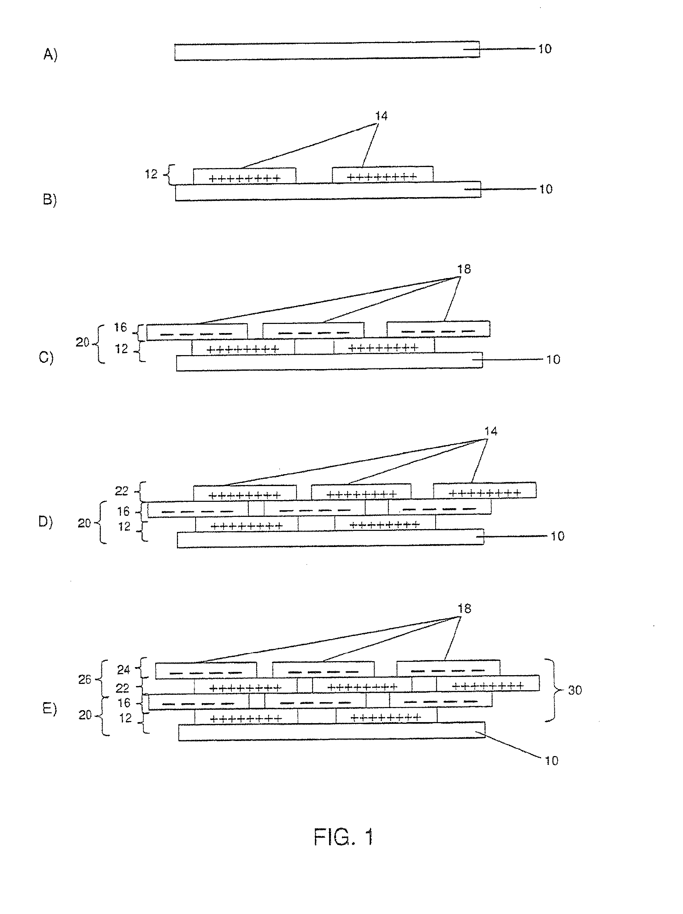

FIG. 1 includes schematic illustrations of assemblies of carbon-based nanostructures in various states of formation. In some cases, the assemblies are formed on substrate 10 (FIG. 1A). The substrate (e.g., the portion of a surface of the substrate on which the assemblies are formed, the whole substrate, etc.) may comprise any suitable material including, for example, metals (e.g., aluminum, steel, copper, gold, tungsten, etc.), semiconductors (e.g., silicon, germanium, GaN, etc.), polymers, among others. In some cases, the substrate material may be chosen such that it is capable of withstanding exposure to the fluids containing charged carbon-based nanostructures.

The assembly may be formed over a portion of a substrate surface having a wide range of surface areas. In some cases, the method may allow for facile and rapid deposition of carbon nanotubes over a large surface area, i.e., several cm² or more. In some cases, the assembly of carbon nanotubes may formed over a surface area of 1 cm², 10 cm², 100 cm², 1000 cm², or greater. In some cases, the method may also allow for formation of the carbon nanotube assembly over a small surface area, including 100 microns² or less, 50 microns² or less, 10 microns² or less, or, in some cases, 5 microns² or less.

The substrate may be selected to have any suitable thickness. For example, in some embodiments, the substrate, or any portion thereof, may be about 10 microns, about 100 microns, about 500 microns, about 1000 microns, about 10 mm, or about 100 mm thick, or thicker. The substrate may comprise any shape suitable for use in a particular application. For example, in some embodiments, the substrate may comprise a circular wafer or a rectangular plate. In some embodiments, the substrate may comprise a three-dimensional shape such as, for example, a solid comprising a complex network of pores. In some embodiments, the substrate may be substantially flat, while in other embodiments, the surface may comprise one or more uneven surfaces.

In some embodiments, one or more portions of a surface of the substrate may be exposed to one or more fluids (e.g., a fluid containing charged carbon-based nanoparticles). As used herein, the term "fluid" generally refers to a substance that tends to flow and to conform to the outline of its container, i.e., a liquid, a gas, a viscoelastic fluid, etc. Typically, fluids are materials that are unable to withstand a static shear stress, and when a shear stress is applied, the fluid experiences a continuing and permanent distortion. The fluid may have any suitable viscosity that permits flow. The fluid may be part of a solution, a suspension, or an emulsion, among others. In cases where the fluid comprises a solvent, any suitable solvent may be used such as, for example, aqueous solvents or organic solvents. Examples of solvents suitable for use in the invention include water, methonol, ethanol, isopropanol, butanol, acetone, butanone, ethers (e.g., diethyl ether, tetrahydrofuran), dimethyl sulfoxide, hydrocarbons (e.g., pentane, hexane, toluene, etc.), dichloromethane, chloroform, and the like. In some embodiments, it may be advantageous to stir the fluid to, for example, form a substantially homogeneous mixture of components, to achieve a substantially consistent concentration of a minor component (e.g., dissolved salt in a solution, carbon-based nanostructures in a suspension, etc.), and/or to reduce precipitation of salts or agglomerated structures (e.g., carbon-based nanostructures). In some embodiments, the fluid comprises a carrier fluid (e.g., in cases where the fluid comprises a suspension). Any suitable carrier fluid may be used such as, for example, any of the fluids mentioned as possible solvents above.

In some embodiments, a first portion of a surface of the substrate may be exposed to a first fluid containing carbon-based nanostructures comprising charged functional groups. The first fluid may contain carbon-based nanostructures comprising either negatively-charged or positively-charged functional groups. In some cases, the first fluid may comprise a carrier fluid in which the carbon-based nanostructures are suspended. As shown in FIG. 1B, exposure of the first portion of a surface of the substrate to the first fluid results in the deposition, proximate the first substrate surface portion, of a layer 12 of carbon-based nanostructures 14 comprising positively-charged functional groups. In some embodiments, carbon-based nanostructures comprising negatively-charged functional groups may be deposited as the first layer. The first portion of a surface of the substrate may be exposed to the first fluid for any suitable amount of time. In some embodiments, the first portion of a surface of the substrate may be exposed to the first fluid for less than about 12 hours, less than about 5 hours, less than about 1 hour, or less than about 30 minutes. In some cases, a first portion of a surface of the substrate may be exposed to the first fluid multiple times (e.g., 2 times, 3 times, more than 3 times, etc.).

After exposure to the first fluid, a second portion of a surface of the substrate, which may be the same or different from the first substrate surface portion, may be exposed to a second fluid containing carbon-based nanostructures comprising charged functional groups. In some embodiments, the first substrate surface portion and the second substrate surface portion (and/or subsequent substrate surface portions) may overlap. In some cases, at least about 20%, at least about 35%, at least about 50%, at least about 70%, at least about 80%, at least about 90%, or more of the first and/or second (and/or subsequent) substrate surface portions may overlap the other (and/or subsequent surface portions). In some embodiments, there may be little overlap between any of the substrate surface portions and any of the other substrate surface portions. In some cases, the second fluid may comprise a carrier fluid in which the carbon-based nanostructures are suspended. In instances where the first fluid comprises a first carrier fluid and the second fluid comprises a second carrier fluid, the first and second carrier fluids may be the same or different. In some embodiments, the second fluid may contain carbon-based nanostructures that comprise functional groups that are oppositely-charged relative to the carbon-based nanostructures in the first fluid. As shown in FIG. 1C, exposure of a second portion of a surface of the substrate in the second fluid results in the deposition, proximate the second substrate surface portion, of a layer 16 of carbon-based nanostructures 18 comprising negatively-charged functional groups. Layers 12 and 16 (of opposite charge) form a bi-layer 20. As mentioned, in some embodiments, the carbon-based nanostructures comprising positively-charged functional groups may be deposited first. The second portion (and/or any subsequent surface portion) of a surface of the substrate may be exposed to the second fluid (and/or any subsequent fluid) any number of times for any suitable amount of time.

In some instances, a third portion of a surface of the substrate, which may be the same or different from the first and/or second substrate surface portions, may be exposed to the first fluid subsequent to the deposition of the first two layers 12 and 16, resulting in the deposition, proximate the third substrate surface portion, of a third layer of carbon-based nanostructures. As shown in FIG. 1D, exposure of a third portion of a surface of the substrate to the first fluid after the deposition of the first two layers results in the formation of a layer 22 of carbon-based nanostructures 14 comprising positively-charged functional groups. A subsequent exposure of a fourth portion of a surface of the substrate, which may be the same or different from the first, second, and/or third substrate surface portions, to the second fluid may result in the formation of a fourth layer of carbon-based nanostructures. In the set of embodiments illustrated in FIG. 1E, this results in the formation of a layer 24 of carbon-based nanostructures 18 comprising negatively-charged functional groups. In FIG. 1E, layers 22 and 24 form bi-layer 26.

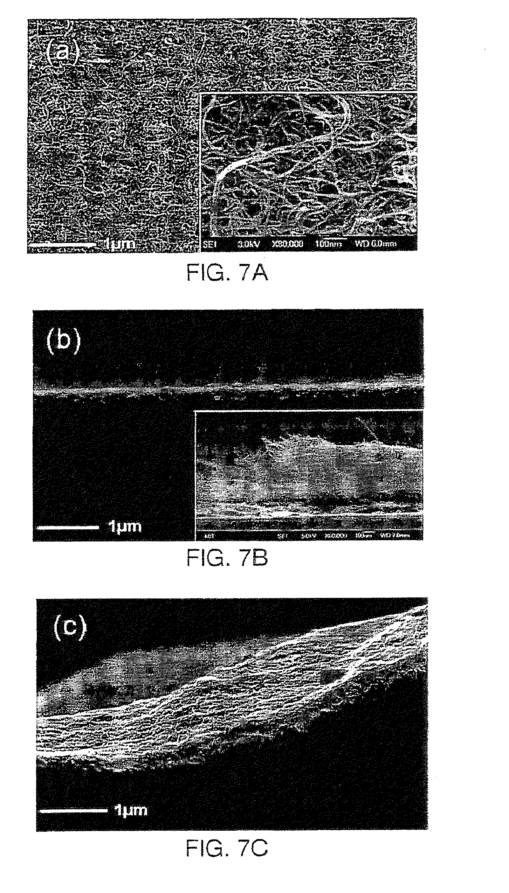

It should be noted that FIGS. 1A-1E (as with all figures) are schematic and are not intended to be drawn to scale. Although the longest dimensions of the carbon-based nanostructures are shown as being substantially parallel to the substrate and each other in this set of illustrations, the nanostrucutres may be oriented in any direction relative to the substrate and/or other nanostructures. In addition, while the layers and bilayers are illustrated as distinct and separated entities in FIGS. 1A-1E, the layers and/or bilayers may intermingle in some cases. In some cases, for example, the layers and/or bilayer may intermingle to an extent such that individual layers and/or bilayers are not visible under microscopy after assembly. An exemplary film of carbon-based nanostructures in which the nanostructures are intermingled is shown in FIG. 7C, which will be described in more detail later.

In some embodiments, rather than alternating the exposures of the portions of a surface of a substrate between two fluids containing complementarily functionalized materials, portions of a surface of the substrate may be exposed to a third, fourth, fifth, and/or more fluids. The third, fourth, fifth, etc. fluid may contain a functionalized carbon-based nanostructure and/or other entity (e.g., a solute, a carrier fluid, etc.) that is different from the nanostructures and/or entities in the first and/or second fluids. For example, in some embodiments, additional fluids may contain polymers, titania nanoparticles, clay nanoparticles, etc. Incorporation of such fluids in the fabrication process may allow for the formation of, for example, layered capacitive structures between layers of carbon-based nanostructure materials. As another example, additional fluids may enable the use of layers of carbon-based nanostructures with varying functionality (e.g., incorporation of a protein receptor on the surface of an assembly of carbon-based nanostructures).

Any number of layers or bi-layers (e.g., at least 1, at least 2, at least 3, at least 4, at least about 10, at least about 100, at least about 1000, etc.) may be formed by performing any number of subsequent exposures of portions of a surface of the substrate in the first and second (or, in some cases, third, fourth, fifth, etc.) fluids. Any of the layers or bi-layers formed on a portion of a surface of the substrate may be of any suitable thickness. For example, in some embodiments, any one of the layers or bi-layers may be at least about 10 nanometers, at least about 100 nanometers, at least about 1 micron, at least about 2 microns, at least about 5 microns, at least about 10 microns, or thicker. In some embodiments, it may be advantageous to form thin layers or bilayers. In some instances, any one of the layers or bi-layers may be less than about 10 microns, less than about 5 microns, less than about 2 microns, less than about 1 micron, less than about 100 nanometers, less than about 10 nanometers, or thinner. A film of one or more layers and/or bi-layers of carbon-based nanostructures (e.g., 30 in FIG. IE) may also have any suitable thickness (e.g., at least about 10 nanometers, at least about 100 nanometers, at least about 1 micron, at least about 2 microns, at least about 5 microns, at least about 10 microns, at least about 100 microns, at least about 500 microns, at least about 1000 microns, or thicker) or thinness (less than about 1000 microns, less than about 500 microns, less than about 100 microns, less than about 10 microns, less than about 5 microns, less than about 2 microns, less than about 1 micron, less than about 100 nanometers, less than about 10 nanometers, or thinner).

In some cases, the nanostructure-coated substrate is treated prior to use in a layer-by-layer method as described herein, i.e., prior to exposure of a portion of a surface of the substrate to a fluid containing carbon-based nanostructures. The treatment may comprise exposure to one or more chemical reagents to enhance the compatibility of a portion of a surface of the substrate with a particular fluid or material. For example, in some embodiments, a portion of a surface of the substrate may be cleaned prior to an exposure to a fluid containing carbon-based nanostructures (e.g., the first exposure to the first fluid containing carbon-based nanostructures). For example, a portion of a surface of the substrate may be exposed to a cleaning solution such as, for example, a piranha solution (H₂SO₄/H₂O₂). In some embodiments, a portion of a surface of the substrate may be exposed to an oxygen plasma. In some embodiments, the cleaning of a portion of a surface of the substrate may result in the formation of a functionalized surface on a portion of a surface of the substrate. In some embodiments, the a portion of a surface of substrate may be rinsed, for example, in deionized water before the first exposure in the first fluid containing carbon-based nanostructures and/or before subsequent exposures to fluids containing carbon-based nanostructures.

In some embodiments, an assembly of carbon-based nanostructures (e.g., one or more layers, one or more bi-layers, a film, etc.) may be heated (e.g., annealed) after its formation (e.g., after deposition onto a portion of a surface of a substrate and/or after detachment from a portion of a surface of a substrate). The heating step may, in some cases, lead to cross-linking between carbon-based nanostructures. In some cases, heating the assembly may produce a change (e.g., an increase or decrease) in one or more properties of the assembly. Examples of properties of the assembly that may be changed upon heating the assembly include, but are not limited to sheet resistance, thickness, tensile strength, elasticity, and/or malleability. An assembly may be heated to any temperature for any duration of time. For example, in some embodiments, the assembly is heated to at least about 50 °C, at least about 100 °C, at least about 150 °C, at least about 200 °C, at least about 300 °C, at least about 400 °C, at least about 500 °C, or higher. In some cases, the assembly is heated for about 1 minute, about 5 minutes, about 15 minutes, about 30 minutes, about 1 hour, about 2 hours, about 12 hours, about 24 hours, or longer. Heating temperatures and times described herein mean exposing an assembly or other device to the stated temperature for the stated time, not necessarily causing all portions of the entire assembly to reach the stated temperature for the stated time. In some embodiments, heating an assembly of carbon-based nanostructures may result in the production of oxygenated species (e.g., C-O bonds, etc.) at the surfaces of the carbon-based nanostructures.

As noted above, the assembly of carbon-based nanostructures may include one or more additional components. For example, the assembly may include polymers, metals, nanoparticles, catalysts, dyes, stabilizers, binders, etc. In some embodiments, the assembly of carbon-based nanostructures may be substantially free of one or more additional components (e.g., the assembly may be substantially free of binder).

In some embodiments, the carbon-based nanostructures may be appropriately functionalized to impart desired characteristics (e.g., surface properties) to the carbon-based nanostructures and/or assembly of carbon-based nanostructures. For example, the carbon-based nanostructures may be functionalized or derivatized to include compounds, functional groups, atoms, or materials that can improve or facilitate formation of the carbon-based nanostructure assembly. In some embodiments, the carbon-based nanostructures may comprise functional groups which can specifically interact with another carbon-based nanostructure to form a covalent bond. In some embodiments, the carbon-based nanostructures may include compounds, atoms, or materials that can alter or improve properties such as compatibility with a suspension medium (e.g., water solubility, water stability) or affinity for a surface (e.g., a portion of a surface of a substrate, a portion of a surface of a layer formed on a substrate). For example, a hydrophilic species may be associated with the carbon-based nanostructure to provide greater hydrophilicity to the carbon-based nanostructure. The hydrophilic species can comprise, for example, amines, thiols, alcohols, carboxylic acids and carboxylates, sulfates, phosphates, a polyethylene glycol (PEG) or a derivative of polyethylene glycol. The carbon-based nanostructures may also comprise functional groups capable of binding an analyte (e.g., via formation of a bond, via interaction between pairs of biological molecules, etc.), such as a biological or a chemical molecule.

In some embodiments, the present invention provides methods for synthesizing charged carbon-based nanostructures. Charged carbon-based nanostructures may be synthesized, in some cases, by substituting or functionalizing the nanostructure. As used herein, the terms "substituted" and "functionalized" are given their ordinary meaning in the art and refer to species which have been altered (e.g., reacted) such that a new functional group (e.g., atom or chemical group) is bonded to the species. In some cases, the functional group may form a bond to at least one atom of a carbon-based nanostructure. In some cases, the functional group may replace another group already bonded to the carbon-based nanostructure such as, for example, a hydrogen atom. In some cases, the functional group (e.g., a ring) may be fused to the carbon-based nanostructure via at least two atoms of the carbon-based nanostructure. Methods of the invention may allow for functionalization of carbon-based nanostructures using a wide range of atoms or chemical groups. In some cases, the present invention may allow for functionalization of multiple groups and/or functionalization at selected locations on the carbon-based nanostructures.

In some cases, the carbon-based nanostructures are functionalized to include one or more negatively-charged atoms or groups, or precursors thereof, to produce negatively-charged carbon-based nanostructures. Examples of negatively-charged groups, or precursors thereof, include carboxylates, sulfates, phosphates, hydroxyl groups, and the like. As an example, negatively-charged carbon-based nanostructures may be synthesized by introducing oxygen-containing groups (e.g., carboxyl groups, carbonyl groups, phenol groups, and sulfonic acid groups, among others). Carbon-based nanostructures may be functionalized with negatively-charged functional groups by, for example, exposing the nanostructures to acids (e.g., strong acids) including, but not limited to, hydrochloric acid, sulfuric acid, nitric acid, phosphoric acid, etc.

In some cases, the carbon-based nanostructures are functionalized to include one or more positively-charged atoms or groups, or precursors thereof, to produce positively-charged carbon-based nanostructures. Positively-charged carbon-based nanostructures may be synthesized by introducing, for example, amine groups (e.g., primary, secondary, and/or tertiary amines). Carbon-based nanostructures may be functionalized with positive functional groups (e.g., amine groups) by, for example, exposing the nanostructures to NH₂(CH₂)₂NH₂. In some cases, carbon-based nanostructures may first be functionalized with oxygen-containing groups (e.g., carboxyl groups, etc.) prior to functionalizing the nanostructures with positive functional groups (e.g., amine groups).

The carbon-based nanostructures described herein may be functionalized with additional functional groups following the introduction of a previously-substituted functional group by using the previously-substituted functional group as an intermediate link between the additional functional group and the carbon-based nanostructures. Examples of additional functional groups that may be attached include, but are not limited to pyridyl groups, pyrolles, anilines, conjugated polymer precursors, among others.

In some embodiments, it may be desirable to control the pH of any fluid containing charged carbon-based nanostructures. For example, in some cases, the thickness of the layers, bi-lavers, and/or assembly may be controlled by controlling the pH (e.g., of a fluid containing carbon-based nanostructures). In some embodiments, the thickness of a layer, bi-layer, and/or assembly may be increased by maintaining a fluid containing positively-charged carbon-based nanoparticles at a relatively low pH during at least one fluid exposure step. In some embodiments, the thickness of a layer, bi-layer, and/or assembly may be increased by maintaining the fluid containing negatively-charged carbon-based nanoparticles at a relatively low pH during at least one fluid exposure step. Any fluid containing carbon-based nanostructures (e.g., the first fluid, second fluid, etc.) may be maintained at any desirable pH during any fluid exposure step. In some cases, the fluid (e.g., first fluid, second fluid, etc.) may be maintained at a pH of about 1, about 1.5, about 2.5, about 3.5, about 4.5, about 6.0, or about 7.0 during any fluid exposure step. In some embodiments, the pH of the fluid (e.g., first fluid, second fluid, etc.) may be between about 1 and about 7, between about 2 and about 6, or between about 2.5 and about 4.5.

Using methods described herein, compositions comprising carbon-based nanostructures may be fabricated in any size, shape, thickness, or other dimension, to suit a particular application. In some embodiments, assemblies of carbon-based nanostructures may be removed from a portion of a surface of the substrate on which they are formed. Removal of the nanostructures may comprise application of a mechanical tool, mechanical or ultrasonic vibration, a chemical reagent, heat, or other sources of external energy, to the assembly and/or the portion of the surface of the substrate on which the assembly is grown. In some cases, an assembly may be detached by exposing the assembly to water, for example. This may cause, in some cases, the assembly to swell and delaminate from a portion of a surface of the substrate on which it is grown. In some embodiments, a portion of a surface of the substrate and/or the bond between the substrate and the assembly may be selectively etched. In some instances, the assembly may be pulled from a portion of a surface of the substrate. In some embodiments, the nanostructures may be removed (e.g., detached) and collected in bulk, without attaching the nanostructures to any portion of a receiving substrate, and the nanostructures may remain in their original or "as-grown" orientation and conformation (e.g., as an assembly of layers) following removal from the growth substrate.

In another aspect, articles, compositions, and devices comprising carbon-based nanostructures are described. In some embodiments, the articles, compositions, and devices described herein may be formed via the layer-by-layer assembly process outlined above.

In some embodiments, the composition may have a relatively low void volume between the carbon-based nanostructures. A composition comprising carbon-based nanostructures may define a composition volume, while each of the carbon-based nanostructures may define a nanostructure volume, which nanostructure volume may include some void space, for example the space defined within a nanotube. In some embodiments, the total of the volumes of the nanostructures defines at least about 60%, at least about 65%, at least about 70%, at least about 75%, at least about 80%, at least about 85% or at least about 90% of the composition volume. In some embodiments, the total of the volumes of the nanostructures defines between about 60% and about 90% of the composition volume.

In some embodiments, an assembly of carbon-based nanostructures may be substantially free of binder and/or other non-carbon materials, resulting in high packing density of the carbon-based nanostructures. In some embodiments, carbon defines at least about 50%, at least about 60%, at least about 70%, at least about 80%, at least about 90%, or at least about 95% of the mass of the solids in the assembly.

In some embodiments, the articles, compositions, and devices described herein may be capable of achieving one or more performance metrics. For example, a component (e.g., one or more electrodes) of a device capable of achieving one or more performance metrics (e.g., a pre-determined capacitance, energy density, specific energy, power, charge efficiency, discharge efficiency, etc., or a combination of any of these in coordination with each other) may comprise an assembly of carbon-based nanostructures. As one example, in some embodiments, a device comprising an electrode comprising carbon-based nanostructures may exhibit supercapacitor behavior. In some embodiments, a device comprising an electrode comprising carbon-based nanostructures may be capable of achieving a capacitance at the electrode of at least about 100, at least about 200, at least about 300, at least about 400, or at least about 450 Farads per cubic centimeter of the electrode. In some cases, a device comprising an electrode comprising carbon-based nanostructures may be capable of achieving a capacitance at the electrode of at least about 100, at least about 200, at least about 300, at least about 400, at least about 500, or at least about 550 Farads per gram of the electrode. As another example, in some instances, a device comprising an electrode comprising carbon-based nanostructures may be capable of achieving an energy density at the electrode of at least about 400, at least about 500, at least about 600, at least about 700, or at least about 750 Watt hours per liter of the electrode. In some cases, a device comprising an electrode comprising carbon-based nanostructures may be capable of achieving a specific energy at the electrode of at least about 500, at least about 600, at least about 700, at least about 800, at least about 850, or at least about 900 Watt hours per kilogram of the electrode.

In some embodiments, a device comprising an electrode comprising carbon-based nanostructures may be capable of achieving a capacitance at the electrode of at least about 50, at least about 75, at least about 100, at least about 125, or at least about 150 Farads per cubic centimeter of the device. In some cases, a device comprising an electrode comprising carbon-based nanostructures may be capable of achieving a capacitance at the electrode of at least about 50, at least about 75, at least about 100, at least about 125, at least about 160, or at least about 185 Farads per gram of the device. As another example, in some instances, a device comprising an electrode comprising carbon-based nanostructures may be capable of achieving an energy density at the electrode of at least about 125, at least about 150, at least about 200, at least about 225, or at least about 250 Watt hours per liter of the device. In some cases, a device comprising an electrode comprising carbon-based nanostructures may be capable of achieving a specific energy at the electrode of at least about 175, at least about 200, at least about 225, at least about 250, at least about 275, or at least about 300 Watt hours per kilogram of the device. Those skilled in the art will know what components are to be included in the volume or mass of the device as described above. Device volumes and masses described herein may include, in some embodiments, the volume or mass of a working electrolytic cell, a working electrochemical cell, a working capacitor, etc. As a non-limiting example, in the case of an electrochemical cell, the volume or mass of the device may include the volumes or masses of the electrode, the counter electrode, the electrolyte, and the device package. Examples of components that might not be included in the volume or mass of a device include, but are not limited to, wiring outside the device package, components outside the package used to house the device, etc.

In some embodiments, articles, compositions, and devices described herein may comprise assemblies of carbon-based nanostructures that are sufficiently thin so as to be transparent to visible light (e.g., 550 nm light, any 100-nm range of wavelengths within the range of 380 to 750 nm). In some embodiments, a 25-bilayer assembly of carbon-based nanostructures may transmit at least about 10%, at least about 15%, at least about 20%, or at least about 25% of incident visible light. In some embodiments, a 20-bilayer assembly of carbon-based nanostructures may transmit at least about 15%, at least about 20%, or at least about 30% of incident visible light. In some embodiments, a 15-bilayer assembly of carbon-based nanostructures may transmit at least about 15%, at least about 20%, or at least about 30%, at least about 40%, or at least about 50% of incident visible light. In some embodiments, a 10-bilayer assembly of carbon-based nanostructures may transmit at least about 15%, at least about 20%, at least about 30%, at least about 40%, at least about 50%, or at least about 60% of incident visible light. In some cases, a 5-bilayer assembly of carbon-based nanostructures may transmit at least about 40%, at least about 50%, at least about 60%, at least about 70%, or at least about 75% of incident visible light. In some instances, a single-layered assembly of carbon-based nanostructures may transmit at least about 60%, at least about 70%, at least about 80%, or at least about 90% of incident visible light.

In some embodiments, an assembly of carbon-based nanostractures up to a thickness of about 250 nm may transmit at least about 15%, at least about 20%, or at least about 30% of incident visible light. In some embodiments, an assembly of carbon-based nanostructures up to a thickness of about 200 nm may transmit at least about 15%, at least about 20%, or at least about 30% of incident visible light. In some embodiments, an assembly of carbon-based nanostructures up to a thickness of about 150 nm may transmit at least about 15%, at least about 20%, or at least about 30%, at least about 40%, or at least about 50% of incident visible light. In some embodiments, an assembly of carbon-based nanostructures up to a thickness of about 100 nm may transmit at least about 15%, at least about 20%, at least about 30%, at least about 40%, at least about 50%, or at least about 60% of incident visible light. In some cases, an assembly of carbon-based nanostructures up to a thickness of about 50 nm may transmit at least about 40%, at least about 50%, at least about 60%, at least about 70%, or at least about 75% of incident visible light. In some instances, an assembly of carbon-based nanostructures up to a thickness of about 10 nm may transmit at least about 60%, at least about 70%, at least about 80%, or at least about 90% of incident visible light. Assemblies of carbon-based nanostructures may exhibit the transmittance properties as a function of thickness and/or number of bilayers described above in coordination with any of the performace metrics (e.g., the capacitance, energy density, specific energy metrics, etc. outlined above and/or the supplied power, charge rates, discharge rates, low energy losses, retention of properties over multiple charge/discharge cycles, etc. to be described below) and/or material properties (e.g., low void volumes between carbon-based nanostructures, free of binder, etc.) associated with assemblies, compositions, and devices described herein.

In some embodiments, a device comprising an electrode comprising carbon-based nanostructures may exhibit fast charge and/or discharge rates. For example, in some embodiments a device comprising an electrode comprising carbon-based nanostructures may be charged to a predetermined capacity (e.g., at least about 50%, at least about 75%, at least about 90%, at least about 95%, or at least about 99%) within about 1 second, within about 10 seconds, within about 30 seconds, within about 1 minute, within about 5 minutes, within about 10 minutes, within about 30 minutes, within about 1 hour, within about 2 hours, or within about 6 hours. In some embodiments a device comprising an electrode comprising carbon-based nanostructures may discharge a predetermined percentage of its capacity (e.g., at least about 50%, at least about 75%, at least about 90%, at least about 95%, at least or about 99%) within about 1 second, within about 10 seconds, within about 30 seconds, within about 1 minute, within about 5 minutes, within about 10 minutes, within about 30 minutes, within about 1 hour, or within about 2 hours.

In some embodiments, the devices described herein may be capable of providing high power outputs. In some cases, devices described herein may be capable of providing power at the electrode at a rate of at least about 100 W per kilogram of the electrode, at least about 1 kW per kilogram of the electrode, at least about 10 kW per kilogram of the electrode, at least about 30 kW per kilogram of the electrode, at least about 300 kW per kilogram of the electrode, or more. In some embodiments, devices described herein may be capable of providing power at the electrode at a rate of at least about 80 W per liter of electrode, at least about 800 W per liter of electrode, at least about 8 kW per liter of electrode, at least about 25 kW per liter of electrode, 250 kW per liter of electrode, or more. Devices comprising carbon-based nanostructures can provide the power outputs described above in coordination with any of the performace metrics and/or material properties associated with assemblies, compositions, and devices described herein.

In some embodiments the amount of energy lost (e.a., as lost heat) during charge and/or discharge of a device comprising an electrode comprising carbon-based nanostructures may be relatively low. In some cases, a device comprising an electrode comprising carbon-based nanostructures may convert at least about 60%, at least about 70%, at least about 75%, or at least about 80% of the energy input to the device during charging to stored energy within the device after charging. In some cases, a device comprising an electrode comprising carbon-based nanostructures may convert at least about 60%, at least about 70%, at least about 75%, or at least about 80% of the energy stored after charging to electricity during discharge.

In some embodiments, low amounts of energy may be lost during charge and/or discharge of the devices at high rates. For example, in some embodiments, a device may convert at least about 60%, at least about 70%, at least about 75%, or at least about 80% of the energy input to and/or stored within the device while the device is charged and/or discharged at any of the rates described above (e.g., at least about 50%, at least about 75%, at least about 90%, at least about 95%, or at least about 99% of the device's capacity charged and/or discharged in as little as 1 second). In some embodiments, a device may convert at least about 60%, at least about 70%, at least about 75%, or at least about 80% of the energy input to and/or stored within the device while the device provides power at any of the rates (e.g., per unit mass and/or per unit volume of the electrode) outlined above. In some cases, devices comprising carbon-based nanostructures may exhibit low energy losses during charge and/or discharge in coordination with any of the performace metrics and/or material properties associated with assemblies, compositions, and devices described herein.

In some embodiments, a device comprising an electrode comprising carbon-based nanostructures may exhibit a consistent capacitance, energy density, and/or specific energy after repeated cycling. For example, in some embodiments, after alternatively charging and discharging a device comprising an electrode comprising carbon-based nanostructures 10 times, the device may exhibit a capacitance, energy density, and/or specific energy of at least about 50%, at least about 65%, at least about 80%, at least about 90%, at least about 95%, or at least about 99% of the device's initial capacitance, energy density, and/or specific energy at the end of the tenth cycle. In some embodiments, after alternatively charging and discharging a device comprising an electrode comprising carbon-based nanostructures 100 times, the device may exhibit a capacitance, energy density, and/or specific energy of at least about 50%, at least about 65%, at least about 80%, at least about 90%, at least about 95%, or at least about 99% of the device's initial capacitance, energy density, and/or specific energy at the end of the 100th cycle. In some embodiments, after alternatively charging and discharging a device comprising an electrode comprising carbon-based nanostructures 1000 times, the device may exhibit a capacitance, energy density, and/or specific energy of at least about 50%, at least about 65%, at least about 80%, at least about 90%, at least about 95%, or at least about 99% of the device's initial capacitance, energy density, and/or specific energy at the end of the 1000th cycle.

Assemblies of carbon-based nanostructures can be incorporated into a variety of devices including, but not limited to, sensors, transistors, photovoltaic devices, electrodes, semiconductors, high strength polymer materials, transparent conductors, barrier materials, energy storage devices (e.g., capacitors), and/or energy production devices (e.g., photovoltaic devices, fuel cells, electrochemical cells, etc.). In some embodiments, a device may comprise one or more electrodes comprising an assembly of carbon-based nanostructures. For example, in some embodiments, a device may include positive and/or negative electrodes (e.g., an anode and/or a cathode) comprising carbon-based nanostructures. The devices described herein may be capable of achieving any one or more of the performance metrics described herein while comprising assemblies and/or compositions possessing one or more of the material properties described herein.

In some embodiments, compositions and/or devices comprising functionalized carbon-based nanostructures may exhibit enhanced properties (e.g., any one or more of the performance metrics and/or material properties described above) relative to compositions and/or devices comprising carbon-based nanostructures that are functionalized to a lesser degree or those that are not substantially functionalized. In some cases, devices comprising carbon-based nanostructures that comprise high percentages of, for example, nitrogen and/or oxygen, may exhibit enhanced properties.

Carbon-based nanostructures (e.g., individual carbon-based nanostructures, assemblies and/or compositions of carbon-based nanostructures, etc.) may be functionalized at various points in a fabrication process. For example, a device may comprise carbon-based nanostructures that are functionalized in solution and deposited, with functional groups attached, in a layer-by-layer process. In some instances, assemblies of carbon-based nanostructures may be functionalized after they are assembled and/or deposited (e.g., during an annealing step, an oxidation step, a chemical treatment step, etc.). For example, in some cases, assemblies of carbon-based nanostructures may be heated in a furnace in which the assemblies are exposed to oxygen, forming carbon-oxygen bonds on the surface of the nanostructures. As another specific example, functional groups comprising oxygen may be attached to an assembly of carbon-based nanostructures by exposing the assembly to one or more acids (e.g., hydrochloric acid, sulfuric acid, etc.). In a still further example, functional groups comprising nitrogen may be attached to an assembly of carbon-based nanostructures by exposing the assembly to NH₂(CH₂)₂NH₂.

Devices comprising assemblies of carbon-based nanostructures that comprise relatively high amounts of oxygen and/or nitrogen may, in some embodiments, provide enhanced performance. In some cases, oxygen defines at least about 10%, at least about 15%, at least about 25%, at least about 40%, at least about 50%, or at least about 58% of the mass of the solids in the assembly. In some instances, nitrogen defines at least about 10%, at least about 15%, at least about 25%, at least about 40%, at least about 50%, or at least about 54% of the mass of the solids in the assembly.

In some embodiments, assemblies comprising functionalized carbon-based nanostructures may be exposed to a fluid comprising ions. The functional groups may interact with positive and/or negative ions, and the ions may be in any oxidation state. In some cases, the functional groups may interact with the ions via proton exchange, electron exchange, or other ion exchange. Ions may interact with any atom of the carbon-based nanostructure (e.g., C, O, N, etc.). Examples of ions that may interact with functionalized carbon-based nanostructures include, but are not limited to Li⁺, Pt²⁺, Pt⁴⁺, V²⁺, V³⁺, PF₆⁻, Cl⁻, or any other suitable ion. General examples of interactions that may occur, in some embodiments, between functionalized carbon-based nanostructures and ions can be illustrated as:

[CBNS]=O + [X]⁺ + e⁻ ↔ [CBNS]-O-[X] (1)

[CBNS]=O-(NH)-C + [Y]⁻ ↔ [CBNS]=O-(NH)-[Y]-C + e⁻ (2)

wherein [CBNS] represents any carbon-based nanostructure, [X]⁺ represents any positive ion, and [Y]⁻ represents any negative ion.

In some embodiments, compositions and/or devices comprising functionalized carbon-based nanostructures that interact with ions may exhibit enhanced properties (e.g., any of the performance metrics and/or material properties described above) relative to compositions and/or devices comprising functionalized carbon-based nanostructures that interact with ions to a lesser degree or those that do not substantially interact with ions.

As an example, in some embodiments, one or more assemblies of carbon-based nanostructures may be incorporated into an electrochemical cell (e.g., as one or more electrodes). The electrochemical cell may comprise, for example, an aqueous or a non-aqueous electrolyte. As an example, in some cases, one or more electrodes of the cell may comprise an assembly of carbon-based nanostructures. In some cases where the electrolyte of a cell comprises one or more electrolyte ions, the one or more electrolyte iocs may interact with the one or more electrodes comprising assemblies of carbon-based nanostructures (e.g., the positive electrode). One or more electrolyte ions (positive and/or negative) may, for example, chemically adsorb onto a surface of the assembly of carbon-based nanostructures. The chemical adsorption process may be, in some cases, reversible during charge and/or discharge of the cell. In some embodiments, one or more electrolyte ions (positive and/or negative) may be intercalated into the assembly of carbon-based nanostructures. The intercalation process may be, in some cases, substantially irreversible during charge and/or discharge of the cell. In some cases, it may be desirable to operate the cell under conditions where no intercalation takes place due to, for example, structural damage of the assembly of carbon-based nanostructures that may, in some embodiments, take place when ions are intercalated within. The chemical adsorption and/or intercalation of electrolyte ions into the assembly of carbon-based nanostructures may, in some cases, lead to enhanced performance (e.g., higher specific energy, energy density, capacitance, etc.) of an electrochemical cell.

An electrochemical cell or an electrolytic cell may comprise any suitable counter-electrode, to be used opposite the electrode comprising carbon-based nanostructures. In some embodiments, the counter-electrode may comprise lithium. For example, the counter-electrode may comprise lithium metal or a iithium-based compound (e.g., Li₄Ti₅O₁₂ (LTO)). An electrochemical cell can be operated at any suitable voltage. In some embodiments, the electrochemical cell may be operated at a relatively low voltage (e.g., less than about 10 volts, less than about 5 volts, less than about 1 volt, between about 0 and about 8 volts, or between about 1.5 volts and about 4.5 volts).

As a specific example, an assembly of carbon-based nanostructures may be incorporated into an electrochemical cell in which the electrolyte comprises Li⁺ ions. In some instances, the Li⁺ ions may chemically adsorb onto the surface of the assembly of carbon-based nanostructures. Not wishing to be bound by any theory, Li⁺ ions may react with negatively-charged atoms (e.g., oxygen atoms) and/or functional groups (e.g., carboxylates, sulfates, phosphates, hydroxyl groups, oxygenated species produced during annealing, etc.).

As another example, an assembly of carbon-based nanostructures may be incorporated into an electrochemical cell in which the electrolyte comprises PF₆⁻ ions. In so me instances, the PF₆⁻ ions may be intercalated into the assembly of carbon-based nanostructures. Not wishing to be bound by any theory, PF₆⁻ ions may react with positively-charged atoms and/or functional groups (e.g., amines, etc.).

In one set of embodiments, an electrochemical cell comprises a positive electrode which comprises an assembly of carbon-based nanostructures. The electrolyte of the electrochemical cell of this set of embodiments comprises LiPF₆ salt dissolved in solution to form Li⁺ and PF₆⁻ ions. In some cases, Li⁺ ions may be reversibly chemically adsorbed onto a surface of the assembly of carbon-based nanostructures within the positive electrode at relatively low operating voltages (e.g., up to 3 V). In some instances, substantially no PF₆⁻ ions are intercalated into the positive electrode at the relatively low operating voltages. In this set of embodiments, PF₆⁻ ions may be substantially irreversibly intercalated into the positive electrode at relatively high operating voltages (e.g., higher than 3 V). In some cases, substantially no Li⁺ ions are chemically adsorbed onto the positive electrode at the relatively high operating voltages.

In some cases, the intercalation of PF₆⁻ ions during a first charge/discharge cycle (which may, in some cases, be substantially irreversible) may reduce the amount of energy stored during subsequent charging cycles. In some embodiments, the intercalation of PF₆⁻ ions during a first charge/discharge cycle may reduce the rate of energy discharge during subsequent discharge cycles.

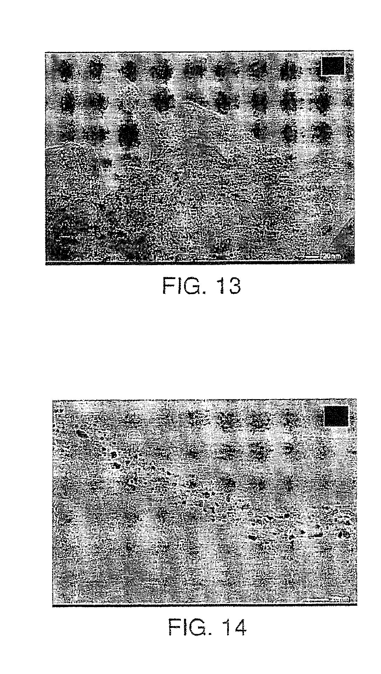

In some embodiments, the carbon-based nanostructure assemblies described herein may be used as a matrix and/or a substrate for the in-situ synthesis of catalysts (e.g., electrocatalysts for energy conversion devices). In some embodiments, a catalyst metal precursor may be attached to a charged carbon-based nanostructure within an assembly. In some cases, the anchored precursor may be reduced *in situ.* As a specific example, a negatively charged Pt precursor (e.g., PtCl₆²⁻) may be attached to a positively charged carbon-based nanotube structure (e.g., an amine group within a positive MWNT thin film). The Pt precursor may then be reduced, for example, by flowing H₂ gas at 300°C to produce Pt particles. FIGS. 13-14 include TEM images of Pt nanoparticles synthesized on MWNTs thin films at (a) low magnification and (b) high magnification.

In some embodiments, the assembly of carbon-based nanostructures may comprise carbon nanotubes. As described herein, the term "carbon nanotube" refers to a substantially cylindrical molecule comprising a fused network of aromatic rings. In some cases, carbon nanotubes may resemble a sheet of graphite rolled up into a seamless cylindrical structure. Carbon nanotubes comprise primarily six-membered rings, but it should be understood that, in some cases, carbon nanotubes may also comprise rings other than six-membered rings. Typically, at least one end of the carbon nanotube may be capped, i.e., with a curved or nonplanar aromatic group. Carbon nanotubes may have a diameter of the order of nanometers and a length on the order of millimeters, resulting in an aspect ratio greater than 100, 1000, 10,000, or greater. The term "carbon nanotube" includes single-walled nanotubes (SWNTs), multi-walled nanotubes (MWNTs) (e.g., concentric carbon nanotubes), inorganic derivatives thereof, and the like. In some embodiments, the carbon nanotube is a single-walled carbon nanotube. In some cases, the carbon nanotube is a multi-walled carbon nanotube (e.g., a double-walled carbon nanotube). In some cases, the carbon nanotube may exhibit metallic and/or semiconductor properties.

In some cases, the assemblies of carbon-based nanostructures may have a substantially uniform thickness over a large surface area (e.g., greater than 200 nm²). A material having a "substantially uniform" thickness may refer to a material having a thickness which deviates less than 10%, less than 5%, or, in some cases, less than 2%, from an average thickness of the material. In some cases, the material may have a substantially uniform thickness over a surface area of at least 200 nm². In some cases, the material may have a substantially uniform thickness over a surface area of at least about 1000 nm², at least about 0.1 square microns, at least 1 square micron, at least 1 mm², at least 1 cm² or, in some cases, greater. In some cases, one or more layers of carbon-based nanostructures may be formed such that they conformally coat a portion of a surface of the substrate.

The following examples are intended to illustrate certain embodiments of the present invention, but do not exemplify the full scope of the invention.

### EXAMPLE 1

In this example, chemically modified multi-wall carbon nanotubes (MWNTs) created using a layer-by-layer (LBL) assembly method are described. In addition, the MWNT thin films were analyzed for use in energy storage and conversion devices. Stable dispersions of negatively and positively charged MWNT solutions were achieved by surface functionalization of MWNTs, allowing them to self-assemble via LBL based on electrostatic interactions. The thickness and surface topology of the MWNT thin films depended upon the pH of the solutions. Atomic force microscopy (AFM), scanning electron microscopy (SEM), and swelling experiments were used to demonstrate that the surface topology and inner structure of the MWNT thin films comprised interconnected random networks which allowed physical entanglement. Sheet resistance and cyclic voltammetry measurements showed that the MWNT thin films could be promising electrode materials with broad scope of design for electrode structures.

### Surface Functionalization of MWNTs

To produce MWNTs for the LBL system, negatively and positively charged MWNTs were created via chemical functionalization of their exterior surfaces. Negatively charged MWNTs were prepared by oxidation with aggressive acids (H₂SO₄/HNO₃), which introduced oxygen-containing groups (e.g., carboxyl groups, carbonyl groups, and phenol groups) to the walls of the MWNTs. Carboxylic acid groups (COOH) on the surface of MWNTs exist as carboxylate anions (COO⁻) in aqueous solution, producing negatively charged MWNTs (MWNT-COOH). Positively charged MWNTs were prepared by introducing amine groups (NH₂) through the formation of amide bonds from COOH functionalized MWNTs. Amine groups on the surface of MWNTs transform into ammonium cations (NH₃⁺), creating positively charged MWNTs (MWNT-NH₂).

To begin, MWNTs prepared by a conventional CVD method were purchased from NANOLAB (95% purity, length 1-5 microns, outer diameter 15 ± 5 nm). MWNTs were refluxed in concentrated H₂SO₄/HNO₃ (3/1 v/v, 96% and 70%, respectively) at 70 °C to prepare carboxylic acid functionalized MWNTs (MWNT-COOH), and then washed with deionized water several times using nylon membrane filter (0.2 microns). Dried, carboxylated MWNTs were chlorinated by refluxing with SOCl₂ for 12 hours at 70 °C. After evaporating any remaining SOCl₂, amine functionalized MWNTs (MWNT-NH₂) were obtained by reaction with NH₂(CH₂)₂NH₂ in dehydrated toluene for 24 hours at 70 °C. After washing with ethanol and deionized water several times, MWNT-NH₂ were prepared as powder form in a drying oven.

### Layer-by-Layer assembly of MWNT Thin Films

Dried MWNT-COOH and MWNT-NH₂ powders were sonicated in Milli-Q water (18 MΩ . cm) for several hours to form stable dispersions. These solutions were subjected to dialysis against Milli-Q water for several days to remove byproducts and residuals during functionalization. The concentrations (0.5 mg/ml) and pHs of the solutions were precisely adjusted after dialysis, and the resulting solutions were sonicated briefly prior to LBL assembly. MWNT films were fabricated with a modified Carl Zeiss DS50 programmable slide stainer on various substrates. Thin, flat magnetic stirrers were installed under the MWNT solutions to circulate the MWNT suspensions during the LBL process.

Substrates were first dipped into MWNT-NH₂ solution for 30 minutes, then three baths of Milli-Q water for 2, 1, and 1 minutes each. Next, the substrates were exposed to MWNT-COOH solution for 30 minutes, and washed in three baths of Milli-Q water for 2, 1, and 1 minutes each. This cycle produced one bilayer of MWNT-NH₂ and MWNT-COOH, denoted (MWNT-NH₂/ MWNT-COOH). The cycle was repeated to produce the desired number of bilayers of MWNT thin films

### Surface Functionalized MWNTs: XPS and zeta potential results

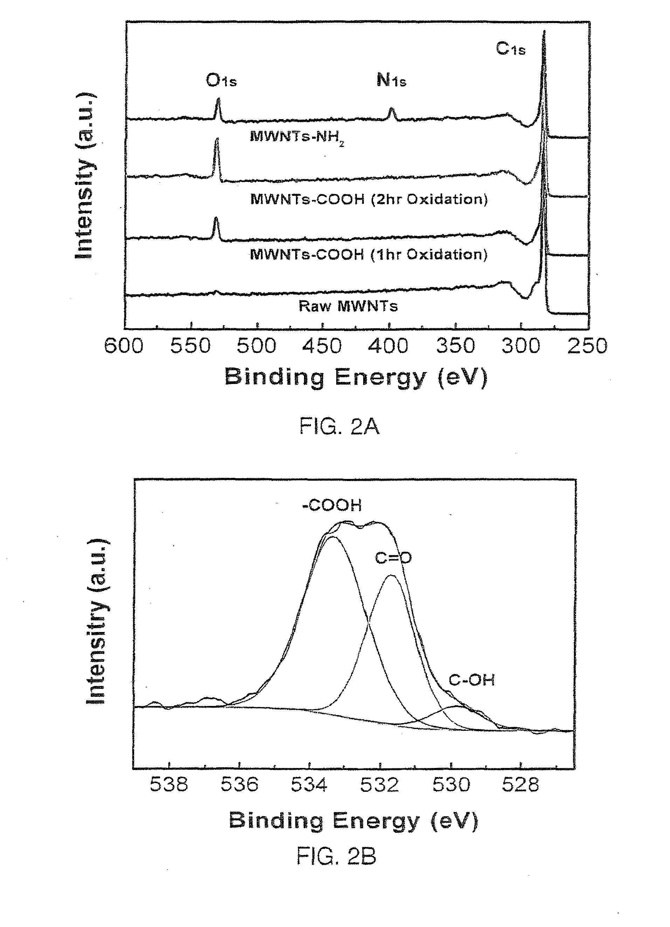

X-ray photoemission spectroscopy (XPS) elemental analysis was performed to probe the surface functional groups on MWNTs as shown in FIG. 2A. A Kratos Axis Ultra XPS instrument (Kratos Analytical, Manchester) with a monochoromatized Al Kα X-ray source was used. The take-off angle relative to the sample substrate was 90°. Curve fitting of the photoemission spectra was performed following a Shirley type background subtraction. An asymmetric C1s peak from sp² hybridized carbons centered at 284.5 eV was generated for raw MWNTs. Using this asymmetric peak as a reference, all other peaks were fitted by the Gaussian-Lorentzian function. The experimental uncertainty on the XPS binding energy was ± 0.1 eV. Relative sensitivity factors used to scale the peaks of C 1s, O 1s, and N 1s were 0.278, 0.780, and 0.477, respectively.

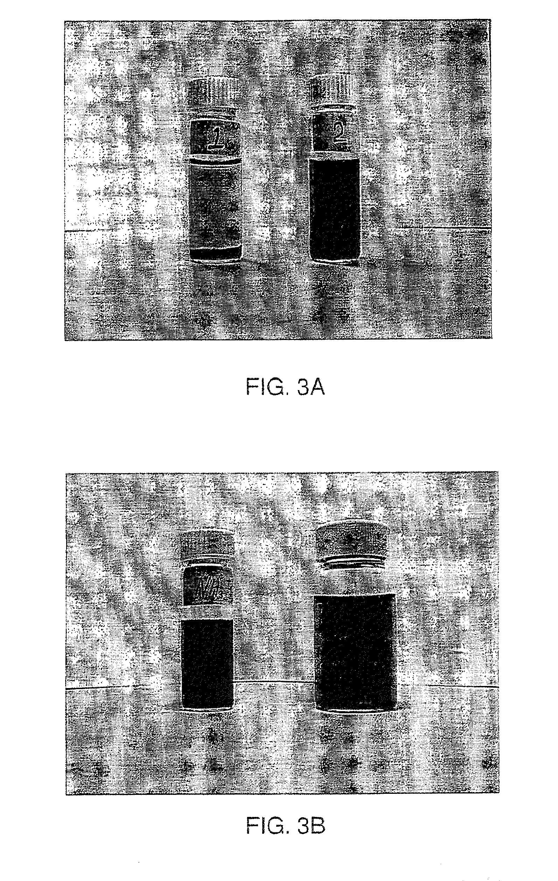

O₁ₛ signals introduced by surface oxidation were clearly observed on COOH functionalized MWNTs and amine functionalized MWNTs. Only NH₂ functionalized MWNTs showed an N₁ₛ signal, indicating the successful formation of amide bonds and the introduction of primary amine groups. The amount of surface functional groups can be controlled by oxidation time, as shown by the increase of peak intensity of O₁ₛ signals as oxidation time was increased from 1 hour to 2 hours. O₁ₛ spectra were fitted to three peaks which were attributed to carboxylic (533.33 eV), carbonyl (531.70 eV), and phenol (529.84 eV) groups, as shown in FIG. 2B. After 2 hours of oxidation, MWNT-COOH showed stable dispersion in water by electrostatic repulsion between MWNTs (FIG. 3A). After only 1 hour of oxidation, however, the number of negative charges was not large enough to prevent gravitational precipitation due to van der Waals interaction between MWNTs. MWNT-NH₂ produced stable dispersions in water after ultrasonication for several hours. Examples of concentrated and diluted amine functionalized MWNTs solution are also shown in FIG. 3B. In the case of diluted MWNTs, there was no precipitation for several days, but small amounts of precipitate were observed in concentrated MWNT solutions after several days. This result suggested that the precipitation rate of positively charged MWNTs was much faster than negatively charged MWNTs, perhaps due to relatively weak electrostatic repulsion between MWNT-NH₂.

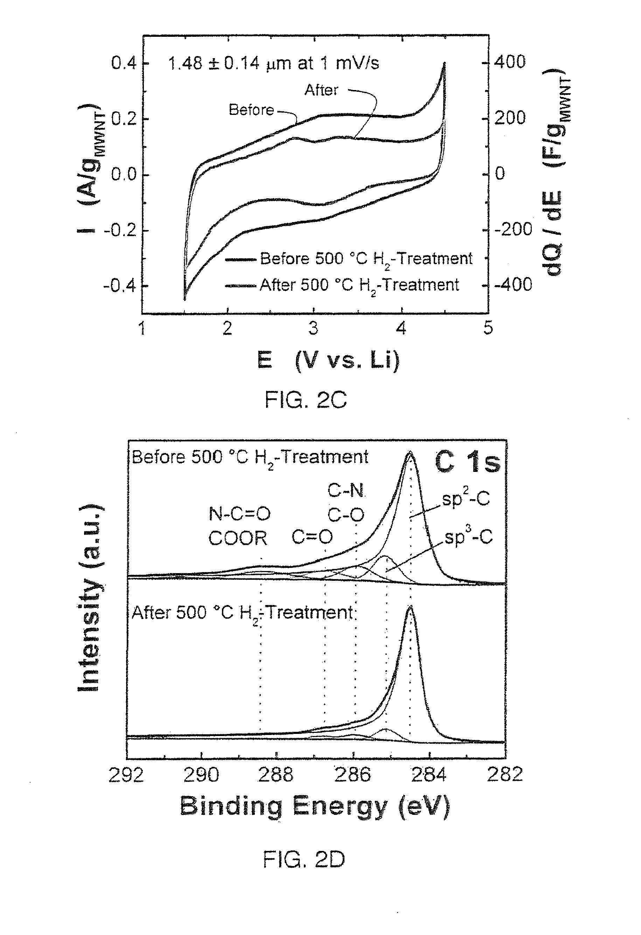

The contribution of surface oxygen and nitrogen functional groups to the high energy storage densities of LBL-MWNTs was further investigated by comparing the performance of LBL-MWNTs before and after exposure to 4 % H₂ and 96 % Ar by volume at 500 °C for 10 hours. Gravimetric current and capacitance values of the LBL-MWNT electrodes decreased considerably (by about 40%) after the H₂ treatment, as shown in FIG. 2C. XPS C 1s spectra analysis showed that this H₂-treatment step decreased the amount of surface oxygen and nitrogen functional groups on MWNTs. sp² and sp³ hybridized carbon atoms were fitted to two peaks at 284.5 eV and 285.2 eV, respectively, as shown in FIG. 2D. The intensities of distinct peaks of higher binding energy, which were assigned to carbon atoms in C-N or C-O centered at 285.9 ± 0.1 eV, carbonyl C=O groups at 286.7 ± 0.1 eV, and amide N-C=O or carboxylic COOR groups at 288.4 ± 0.1 eV, was reduced greatly (by about 70 %) after the H₂ treatment. Therefore, this experiment provides further evidence that the redox of surface oxygen and nitrogen functional groups can contribute to the large gravimetric capacitance of LBL-MWNT electrodes in nonaqueous systems.

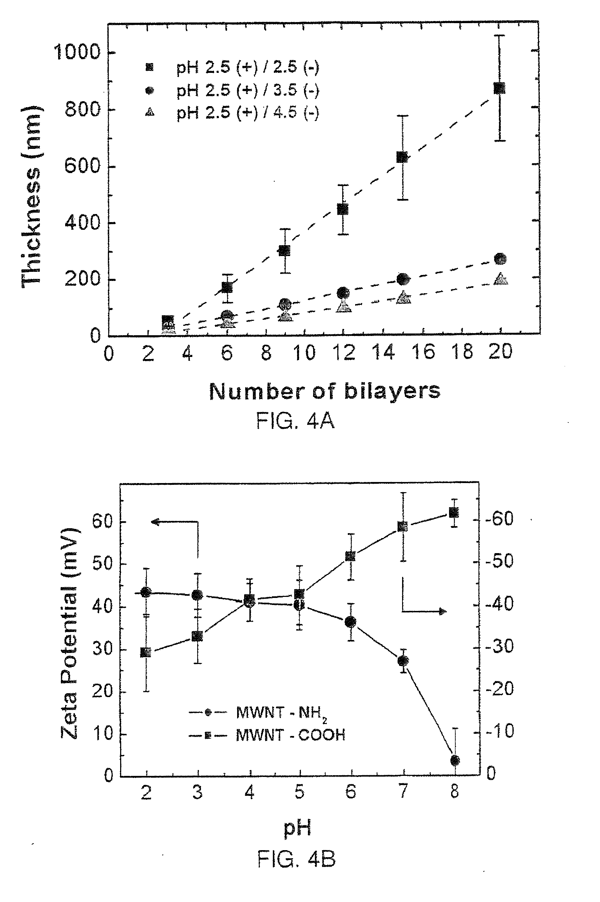

The surface charges of MWNTs can be a key factor in creating stable colloidal dispersions and subsequent control of the quality of LBL-assembled films. Zeta potential as a function of pH was measured to investigate the effect of surface charges of MWNT dispersions on stability. As shown in FIG. 4B, the zeta potential of MWNT-COOH decreased with decreasing pH since the degree of ionization of MWNTs also decreases. On the other hand, the zeta potential of MWNT-NH₂ decreased as the pH increased since the degree of ionization of the MWNTs decreased. This behavior was similar to that observed with weak polyelectrolytes such as poly(acrylic acid) (PAA) and poly(allylamine hydrochloride) (PAH). Hence, it was believed that MWNTs could be directly incorporated into multilayer films by electrostatic interactions, and it was also expected that the thickness and morphology of the resulting LBL films could be controlled by altering the assembly pH, as can be done using weak polyelectrolytes. To exclude the effect of slow precipitation of MWNTs in the solution at long time scales (e.g., several days), a flat stirrer was installed to circulate the MWNT solutions while layering on the substrate. This allowed for the production of uniform, fine-quality MWNT thin films on the substrate.

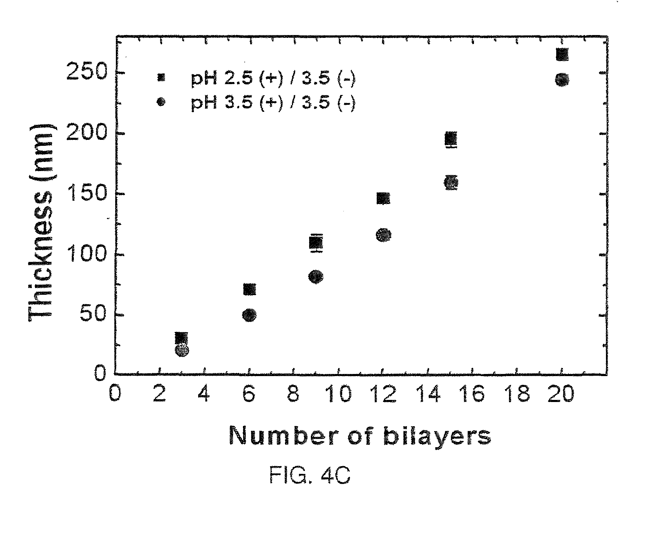

FIG. 4A illustrates the growth behavior of MWNT thin films under various pH conditions as a function of the number of bilayers. For convenience of comparison, the following notation will be adopted going forward: MWNT films assembled from MWNT-NH₂ at a pH of 2.5 and MWNT-COOH at a pH of 3.5 will be denoted as pH 2.5 (+) / 3.5 (-). The pH of MWNT-COOH was varied from 2.5 to 4.5 while fixing the pH of MWNT-NH₂ at 2.5 with sufficient surface charges. The thickness per bilayer of the MWNT films increased as the pH of MWNT-COOH decreased. Not wishing to be bound by any theory, the increase in thickness from pH 4.5 to 2.5 may have been due to the significant charge decrease of carboxylic acid functionalized MWNTs from pH 4.5 to pH 2.5, thus requiring more adsorption of negatively charged MWNTs to balance the charge for each bilayer. This hypothesis is supported by zeta potential measurements (FIG. 4B). The thickness changes as a function of the change in the pH of positively charged MWNTs (while maintaining a constant pH of the negatively-charged MWNT) were measured in comparison, the results of which are shown in FIG. 4C. FIG. 4C, shows an increase in thickness as the pH of the positively charged MWNT solution was decreased, but the increase in thickness was not as large as the increase that was observed in FIG. 4A.

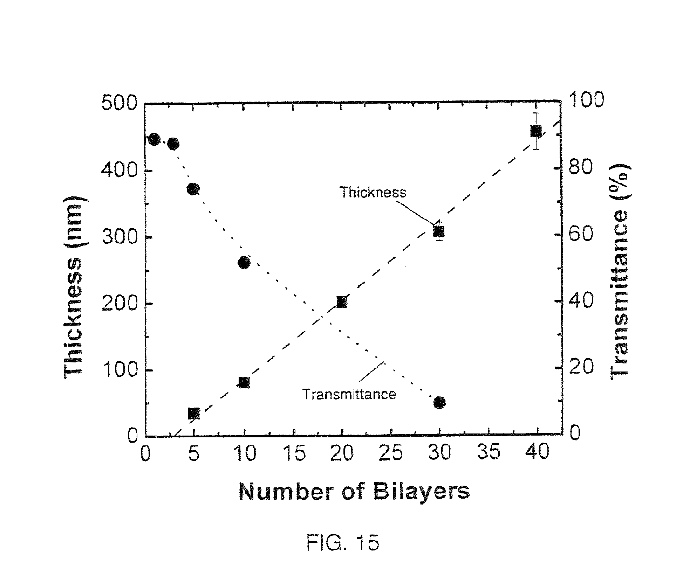

Assemblies of carbon-based nanostructures were at least partially transparent to visible light in some instances. FIG. 15 includes a plot of thickness of the assembly of carbon-based nanostructures and the transmittance of 550 nm electromagnetic radiation through the carbon-based nanostructures as a function of the number of bilayers for one set of embodiments. From the plot, it can be seen that the assembly of carbon-based nanostructure was able to transmit more than 50% of the light at a wavelength of 550 nm.

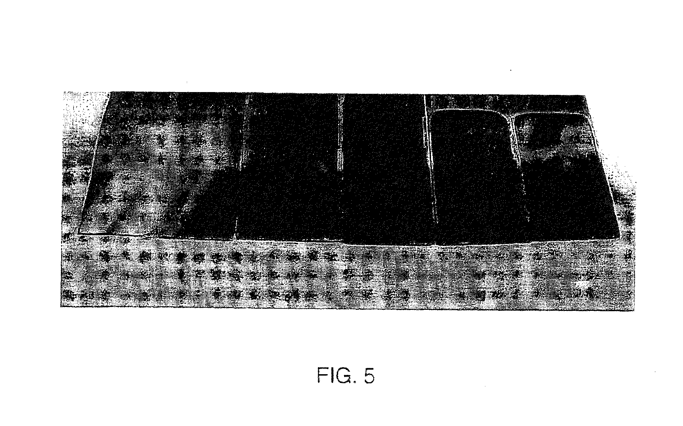

FIG. 5 includes representative digital picture images of MWNT thin films on Si wafers from pH 2.5 (+) / 4.5 (-). From FIG. 5, it can be seen that each film has a characteristic reflective color corresponding to its thickness.

### Microstructure and Swelling Behavior of Surface-Functionalized LBL MWNTs

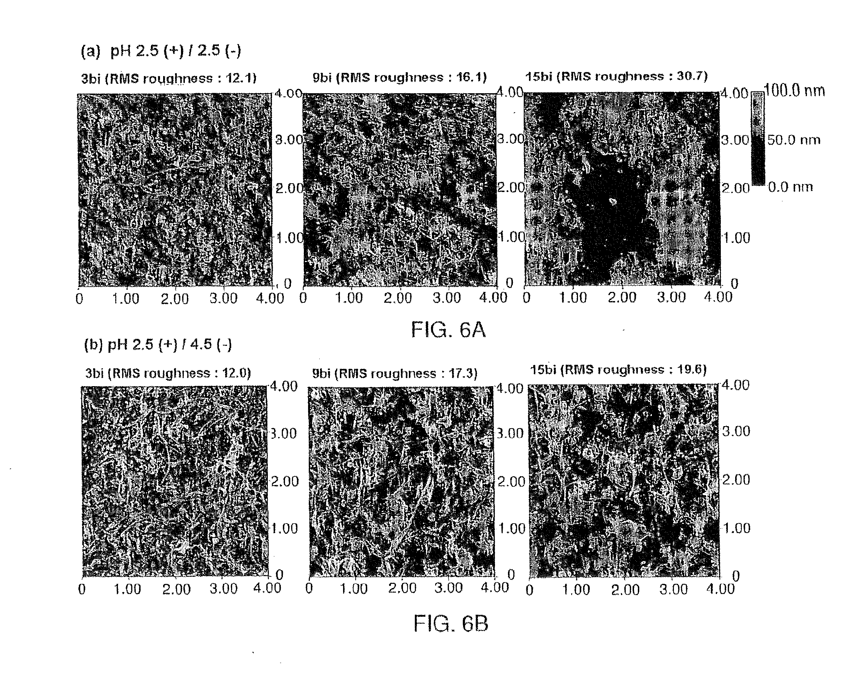

Surface morphology and interior structure of MWNT thin films were investigated using an atomic force microscope (AFM) and a scanning electron microscope (SEM). FIG. 6 shows tapping-mode AFM images of MWNT thin films assembled at different pH conditions with an increasing number of bilayers. All AFM images clearly showed MWNT thin films that had an interconnected network structure including individual MWNTs which had average diameters of about 15 ± 5 nm. Root-mean-squared (RMS) roughness increased with the number of bilayers. Similar behavior was observed for different pH conditions at the early stages, but assembly from pH 2.5 (+) / 2.5 (-) produced a steep increase of RMS roughness from 9 bilayers to 15 bilayers, relative to assemblies under other pH conditions. Not wishing to be bound by any theory, this might be due to insufficient surface charge densities of MWNT-COOH at pH 2.5, resulting in loose adsorption of large amounts of MWNTs, producing relatively rougher surfaces. In contrast, assembly of MWNT-COOH at a higher pH show relatively uniform and densely packed MWNTs network structures. (Images of MWNTs fabricated under pH 2.5 (+) / 3.5 (-) conditions were omitted here because of the resemblance of the topography to MWNTs fabricated under pH 2.5 (+) / 4.5 (-) co nditions.)

A porous network structure of MWNTs thin films weaved with individual MWNTs was observed using top view SEM (FIG. 7A). Enlargement of FIG. 7A shows nano-scale pores between the MWNTs. This may make MWNT thin films relatively more suitable for use in electrode structures, as they provide mixed ionic and electronic conducting channels. A cross-sectional view of MWNT thin films (FIG. 7B) shows a conformal and uniform coating of MWNTs on a silicon wafer. This suggests that the MWNTs may be applied to a variety of substrate shapes, without geometric constraint. Interestingly, the film in the enlargement of FIG. 7B shows most of the MWNTs in the film are not parallel with the substrate, but rather are tilted, forming an interpenetrating structure with elements oriented in the vertical as well as the horizontal directions. FIG. 7C includes an intermediate view created by cutting a film at a slant, more clearly showing the internal structure of the film. Since the MWNTs have intrinsically high electrical conductivity and surface area, these porous network structures can provide fast electronic and ionic conducting channels. This may yield clues as to how to design the ideal matrix structure for energy conversion and storage devices.

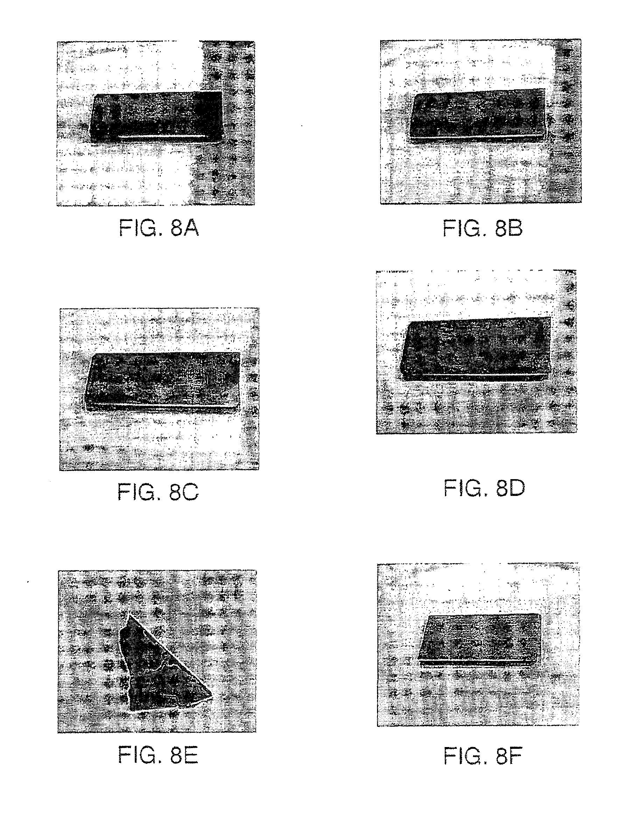

The time-dependent swelling behavior of MWNT thin films in water was also investigated. MWNT thin films (about 156 ± 6 nm in thickness) assembled at pH 2.5 (+) / 4.5 (-) on an Si substrate were immersed in deionized water. Small blisters were formed immediately in the center region of the film. The blisters then quickly grew and coalesced to form large blisters whose boundaries reached the edges of the substrate (as shown in FIGS. 8A-D). Not wishing to be bound by any theory, there may have been electrostatic repulsions between negatively charge MWNTs in the film due to charge imbalance induced by increasing the degree of ionization of NH₂ (NH₃+) groups, and decreasing the degree of ionization of COOH (COO-) groups in the water (pH ∼ 6.0). Not wishing to be bound by any theory, when the film was swollen in water, the film may have been able to expand freely through its thickness, but confined laterally due to being bound by the substrate. This may have created strain in the lateral direction. As a result, the generation of blisters and the delamination of the film from the substrate may have commenced in order to release excess strain energy in the film. This may have begun at any point at which the strain energy was larger than the adhesion energy between the film and the substrate. Although individual MWNTs were quite elastic, ch anges in their conformation were difficult to achieve due to their rigidity. Physical entanglements existed in the films due to their large aspect ratios and sinuous structures. This led to viscous flow of MWNTs during the swelling process. The dissipation of energy during the viscous flow of MWNTs may be similar to the mechanism of releasing strain energy in the film. After adding water, a free-standing MWNTs film was isolated after shaking the substrate. FIG. 8E includes a photograph of a free-standing MWNT thin film after swelling and subsequent delamination of the film from the substrate. As shown in the figure, the structural integrity of the film was maintained.

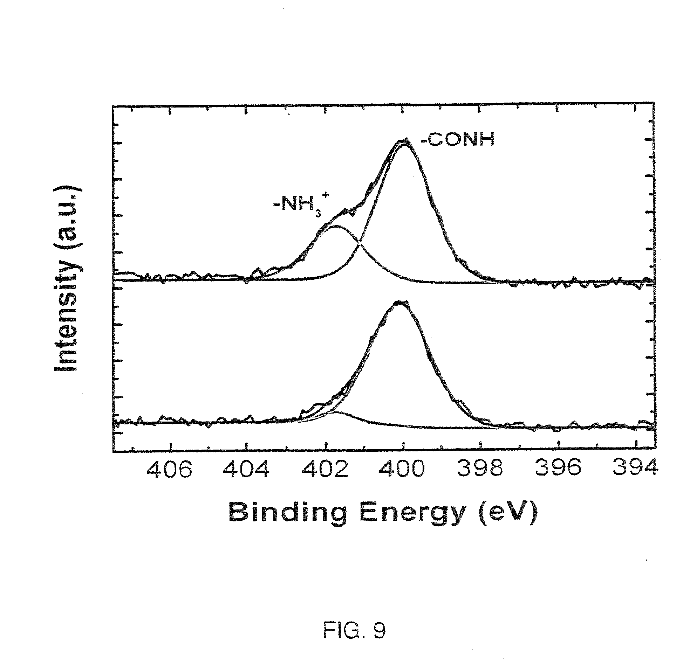

To increase the mechanical integrity, the MWNT thin films were heat treated. Not wishing to be bound by any theory, the heat treatment may have induced cross-linking of the MWNT thin films, which may have created, for example, amide bonds between NH₃⁺ and COO⁻ groups. XPS peaks of N₁ₛ regions before and after heat treatment (shown in FIG. 9) show a significant decrease in the ammonium peak after heat treatment, indicating the formation of an amide bond from charged ammonium groups. FIG. 8F shows that, once cross-linked, the MWNT thin film was resistant to swelling, preserving its original shape in water. In one example, sequential heat treatments of MWNT electrodes were performed at 150 °C in vacuum for 12 hours, and at 300 °C in H₂ for 2 hours to increase mechanical stability. During heat treatments in this example, the thickness of MWNT electrodes decreased about 10%, which generated a more closely packed MWNT network structure.

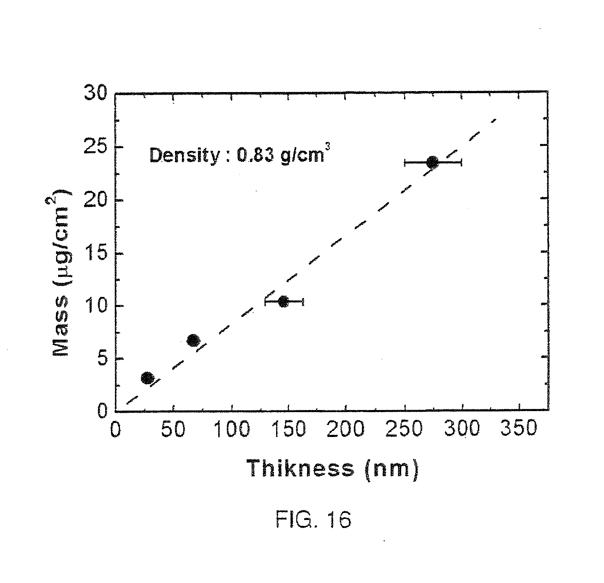

The density of a MWNT electrode was determined to be about 0.83 g/cm³ after heat treatment, as determined by the slope of the plot of the mass against thickness, shown in FIG. 16. In this example, the measured mass was determined using a quartz crystal microbalance (Masscal G1 QCM/HCC), and the thickness was determined using a Tencor P-10 profilometer. The thickness of each MWNT electrode was determined by averaging the thickness at at least three different locations on each electrode using the profilometer. The volume of each electrode was determined by multiplying the average thickness by the geometric area of the electrode, and was converted to the mass using the density.

The porosity of MWNT electrodes was estimated to be about 30%. The porosity was calculated by comparing the density of MWNT powder (about 1.2 g/cm³) to the electrode density (0.83 g/cm³).

### Electronic Resistance of Surface-Functionalized LBL MWNTs

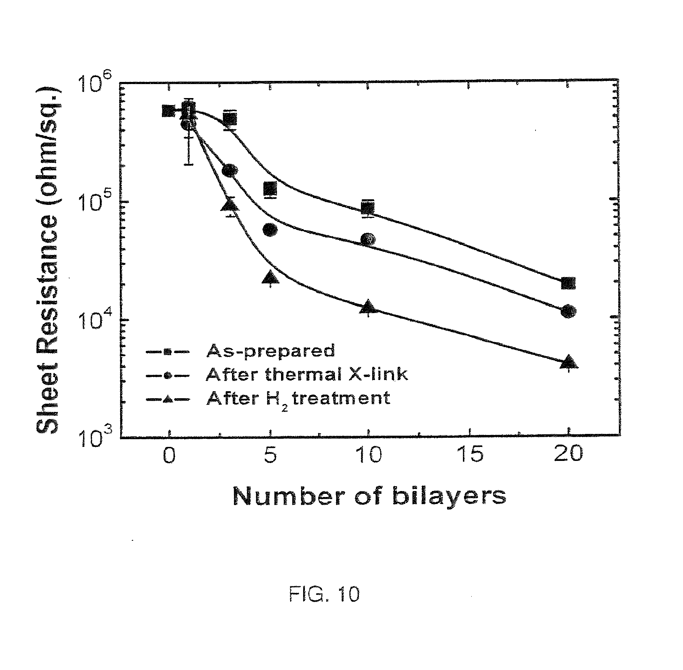

The sheet resistance of MWNT thin films as a function of the number of bilayers was measured by 4-point probe. FIG. 10 includes the results of measurements taken for MWNT thin films assembled at pH 2.5 (+) / 3.5 (-) on a glass substrate. The sheet resistance of as-prepared samples showed high values. Not wishing to be bound by any theory, this may have been due to the breaking of sp2 bonds on the exterior surfaces of the MWNTs and the formation of surface functional groups. The sheet resistance decreased with an increase in the number of bilayers. Chemical cross-linking of an MWNT thin film at 150 °C in vacuum decreased the sheet resistance by half. Not wishing to be bound by any theory, this may be explained by the facilitation of electron flow through amide bond. Following heat treatment at 300 °C in hydrogen atmosphere for 2 hours, the sheet resistance of the MWNT thin film was further decreased, showing an average of an 82% reduction compared to as-prepared samples. Accounting for the decrease in thickness (∼10%) during heat treatment, the normalized electrical conductivities of the heat treated MWNT thin films were about 6 times larger compared to as-prepared MWNT thin films. Further increases in electrical conductivity may be accomplished by further increasing the temperature of the heat treatment, but the effects of thickness compression should also be considered. In summary, these results showed that post-heat treatment of MWNT thin films can increase the electrical conductivity as well as the mechanical integrity.

### Electrochemical properties of LBL-MWNT electrodes

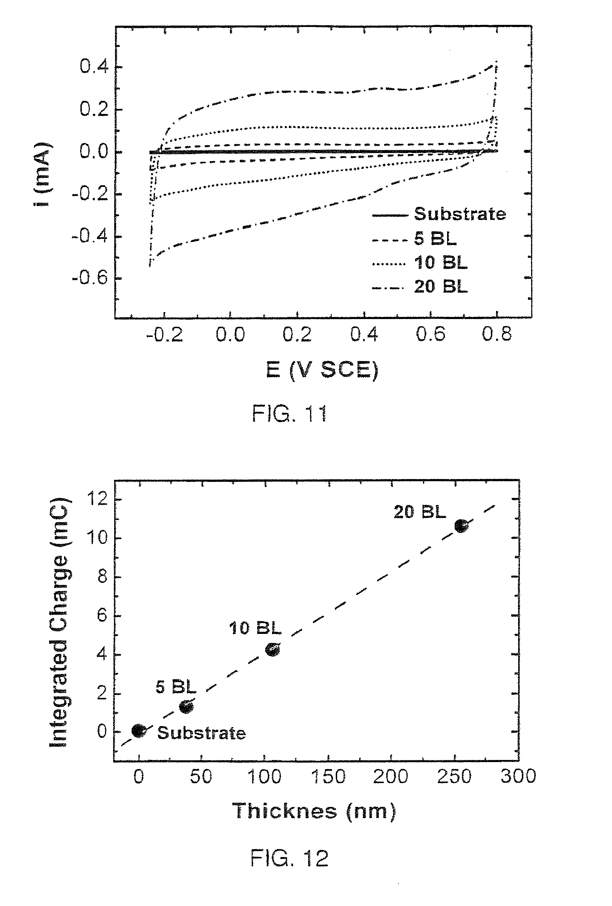

Cyclic voltammograms of heat treated MWNT thin films as a function of the number of bilayers are shown in FIG. 11. The samples used for these measurements were 0.7 cm × 2 cm thin films formed on ITO-coated glass. The films were assembled at pH 2.5 (+) / 3.5 (-) and soaked in 1.0 M H₂SO₄ solution. The thickness dependent voltammetry curves were rectangular in shape at high scan rates (∼100 mV/s), a common feature of general capacitor behavior of carbon materials. Integrated surface charges from adsorbed and desorbed ions on MWNT thin film electrodes were plotted as a function of film thickness, as shown in FIG. 12. The linearity of the plot suggests that pinpoint control of the capacitance of the electrode may be achieved by controlling the number of bilayers. LBL assembly may be particularly well-suited for this purpose as it provides highly controllable film thicknesses that scale with the number of bilayers.

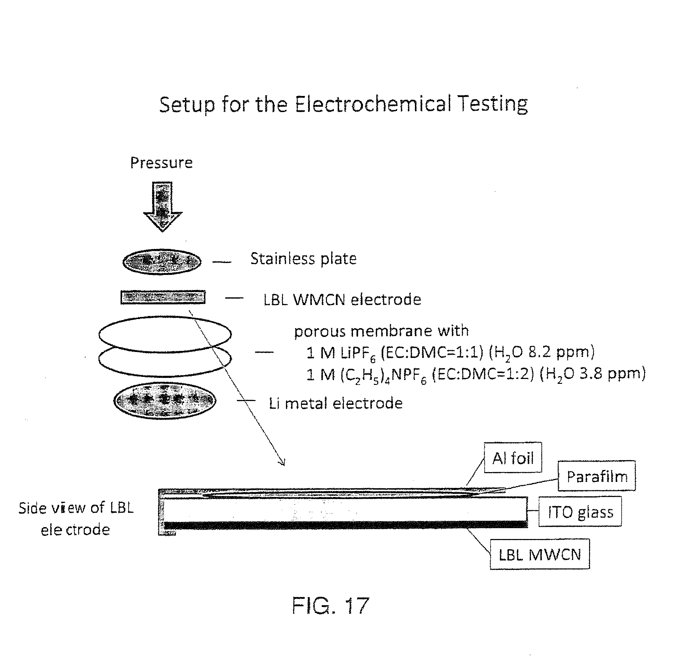

In another set of experiments, electrochemical properties of a LBL-MWNT electrode were examined. The LBL-MWNT electrode was formed using techniques similar to those outlined in Example 1. FIG. 17 includes a schematic diagram of the electrochemical testing setup used in this set of experiments. The testing was carried out by using a two-electrode electrochemical cell (Tomcell Co. Ltd., Japan). A LBL multi-walled carbon nanotube (LBL-MWNT) electrode on ITO glass (0.7 cm × 1.5 cm) was used as a positive electrode, while lithium metal was used as a negative electrode. Al foil was attached to one side of the LBL-MWNT electrode and used as an electrical lead to the cell. Two sheets of microporous membrane (Celgard 2500, Celgard Inc., USA) were used as a separator. The electrolyte solution comprised 1 mol/L LiPF₆ dissolved in ethylene carbonate (EC) and dimethyl carbonate (DMC) (3/7 by volume, 3.5 ppm H₂O impurity; Kishida Chem., Corp. Ltd., Japan). The separators were wetted using the minimum amount of electrolyte solution adequate to achieve acceptable wetting in order to minimize background current. Cyclic voltammetry and galvanostatic measurements of lithium cells were performed using Solartron 4170 at room temperature.

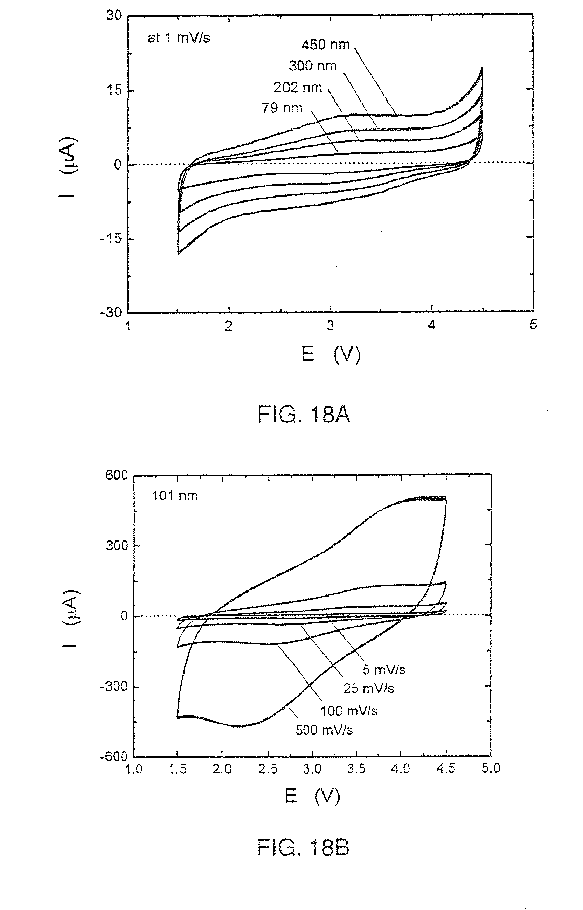

The electrochemical properties of the MWNTs on the ITO coated glass were examined, and results are shown in FIGS. 18A-18D. Slow scan cyclic voltammetry was measured at 1 mV/s in the voltage range from 1.5 to 4.5 V vs. Li metal negative electrode (FIG. 18A). Since the absolute value of the current was less than 20 µA, polarization at the lithium negative electrode was considered to be minimal. The current increased as the thickness of the electrode increased. Current peaks in the anodic scan and the cathodic scan were observed. In addition, steep current increments were observed near 4.5 V and 1.5 V for both the anodic and cathodic scans, respectively. The total capacity (and/or capacitance) was calculated to be 160 mAh/g (210 F/g as average) by integration of the observed current in this potential range. These values were anomalously high based on the reported value for the conventional carbon materials including MWNT. If it is assumed that all of the capacitance originated from electrochemical double layer charging at an inhomogeneous interface between the LBL-MWNTs and the electrolyte solution, specific capacitance per unit area was calculated to be 100 µF/cm² based on the observed surface area of conventional MWNT (∼ 400 × 10⁴ cm²/g). Since the conventional observed value is 20-30 µF/cm² for a planar electrode, the value was likely not due to electrochemical double layer charging at the electrode surface alone.

In order to study the origin of the anomalous capacity as a carbon material, cyclic voltammetry was performed at higher scan rate (from 5 to 500 mV/s, shown in FIG. 18B). Similar peaks that were observed at a rate of 1 mV/s were still present at 500 mV/s, whereas the peaks near 4.5 and 1.5 V became unclear as the current density was increased. These results suggested that some reversible redox reactions were causing the current peaks observed around 3 V. Not wishing to be bound by any theory, the large capacity, as a carbon material, may have thus originated from not only electrical double layer charging, but also the reversible redox reactions (in other words, so-called "pseudo-capacitance") with relatively fast kinetics.

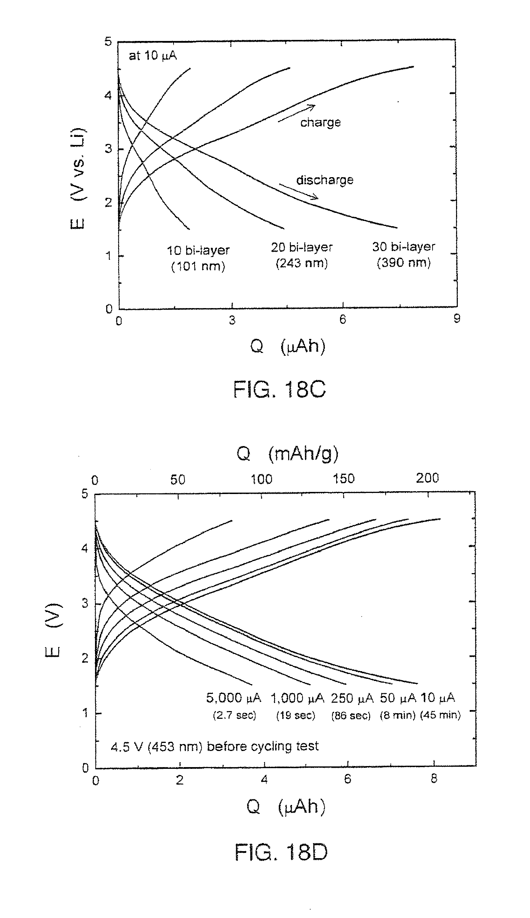

Electrochemical properties of the LBL-MWNT were further examined by constant current measurements. FIG. 18C shows charge and discharge curves of a LBL-MWNT sample at a rate of 10 µA in the voltage range of 1.5 to 4.5 V vs. Li metal. The thicknesses of the samples measured by the profilometer were 100, 200, and 400 nm. As can be seen in FIG. 18C, the capacity increased almost linearly with an increase in the thickness of the samples. Although the linear profile of the charge and discharge curves resembled conventional electrochemical capacitors, a detailed analysis revealed that the intrinsic character may have been quite different. FIG. 18D illustrates the charge/discharge rate-capability of the Li/LBL-MWNT cell at a constant current of 10 - 5,000 µA, corresponding to 0.25 - 127 A/g. Before each charge/discharge measurement, the cell was charged and discharged at a constant voltage of 4.5 V and discharged at 1.5 V for 30 min, respectively. A discharge capacity of 200 mAh/g was obtained at 10 µA for *ca*. 45 min. During discharging, the cells could deliver *ca*. 40 % of capacity at 5,000 µA for a time as short as less than 3 sec. The slope of the discharge curves was almost linear, from which the capacitance was calculated to be *ca.* 400 F/g. The charging kinetics seemed to be similar to the discharging kinetics. The cell was capable of storing *ca*. 60 % of capacity within 20 sec.

### The origin of the high capacity for the LBL-MWNT electrodes

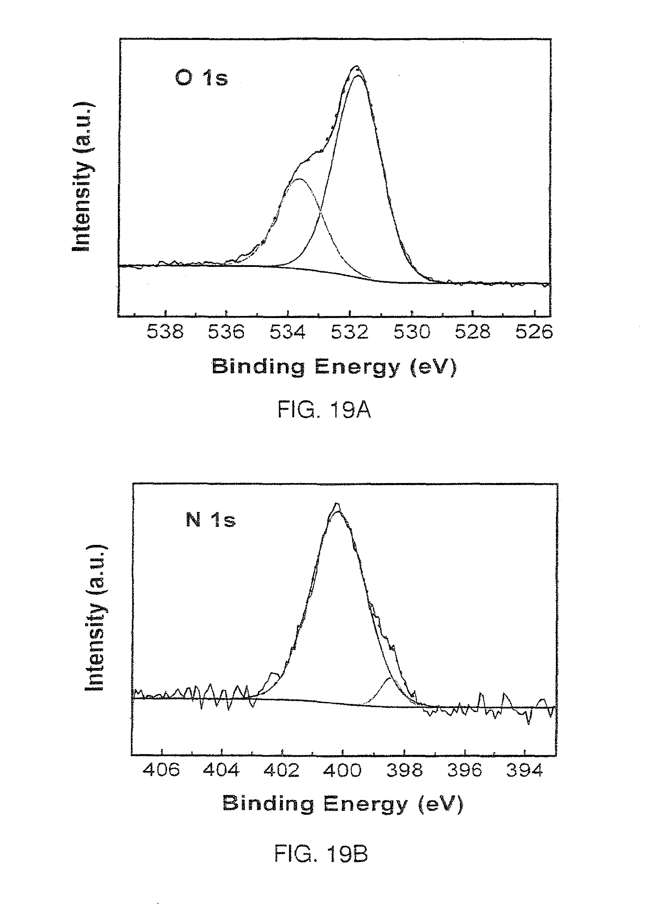

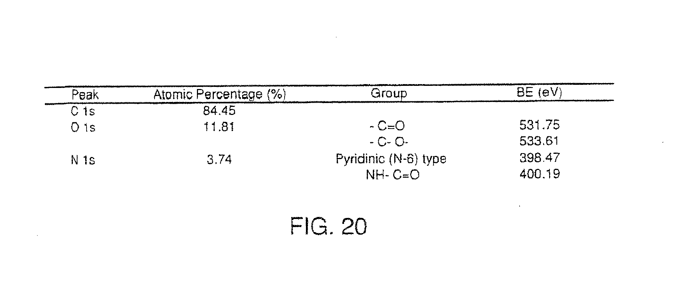

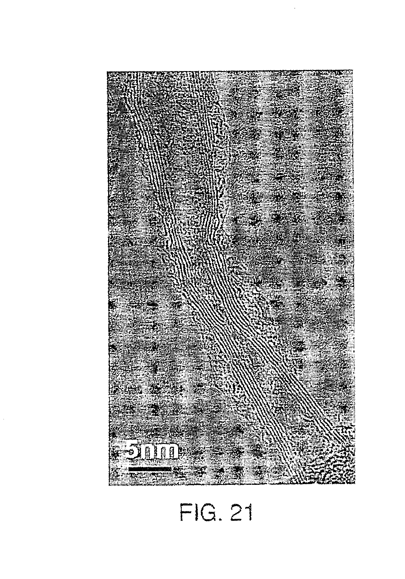

Since chemical functionalization of the basal plane (or exterior planes) of the CNTs was utilized for LBL assembly, it was believed that the functionalized groups on the basal plane may have been responsible for redox reactionsas that may have been evidenced from the cyclic voltammograms. To understand the nature of the chemically modified basal plane of the samples, X-ray photoemission spectra of MWNT electrodes after heat treatment were collected. O 1s and N 1s spectra are shown in FIGS. 19A-B, and atomic compositions are shown in FIG. 20. The atomic composition of the MWNT electrode (FIG. 20) after heat treatment was C = 84.45%, O = 11.81%, and N = 3.74%, showing introduction of significant amount of oxygen and nitrogen groups into MWNTs by surface functionalization. Examples of oxygen and nitrogen derivatives believed to have been present after heat treatment were carbonyl (531.75 eV) and amide groups (400.19 eV). Oxygen and nitrogen derivatives can contribute to pseudocapacitance by redox reactions in both aqueous and non-aqueous electrolytes; not wishing to be bound by any theory, a part of high capacity of the MWNT electrode may be due to their presence. The surface structure of MWNT electrodes after heat treatment was investigated by a HRTEM (JEOL 2010F electron microscope) image (FIG. 21), which showed defects of exterior sheets and formation of an amorphous coating on graphene sheets which may have been induced by strong oxidation during surface functionalization. The lateral defects on the surface of the MWNT may have facilitated the insertion and extraction of PF₆⁻ ions and increased interface area available to electrolytes.

To examine intrinsic electrochemical double layer capacitance and differentiate the pseudo-capacitance from total capacitance, cyclic voltammetery was conducted in 1 mol/L H₂SO₄, and the results were compared with those obtained from a nonaqueous system using a similar potential range based on the standard hydrogen electrode (SHE). The potential range examined was 0 - 1.23 V vs. SHE (the same as RHE in this case) in 1 mol/L H₂SO₄, in contrast to the range of 3.00 - 4.25 V vs. Li metal in 1 mol/L in LiPF₆ EC/DMC solution. The capacitance was calculated to be 200 F/g in H₂SO₄ at 10 mV/s and 190 F/g at 10 mV/s in the nonaqueous system. The inhomogeneous interface between the LBL-MWNT and the electrolyte solution may have been particularly large due to the three-dimensional pathway and uniform pore size distribution in the LBL-MWNT. Not wishing to be bound by any theory, the high capacitance per volume may have been related to a number of factors including, for example, the densification of the MWNTs, the formation of an interconnected porous network for ion transport, and/or the presence of pseudo-capacitance between oxygen and amine derivatives on the surfaces of the MWNTs, among other factors. The observation of a decrease in capacitance with an increase in scan rate may support the existence of pseudo-faradic charge transfer reactions, such as, for example, the following (wherein MWNT represents the multi-walled nanotube structure):

MWNT-C=O + H⁺ + e⁻ ↔ MWNT-C-OH (3)

MWNT-C=O + e⁻ ↔ MWNT-C-O⁻ (4)

MWNT-CONH- ↔ MWNT-CONH⁺ + e⁻ (5)

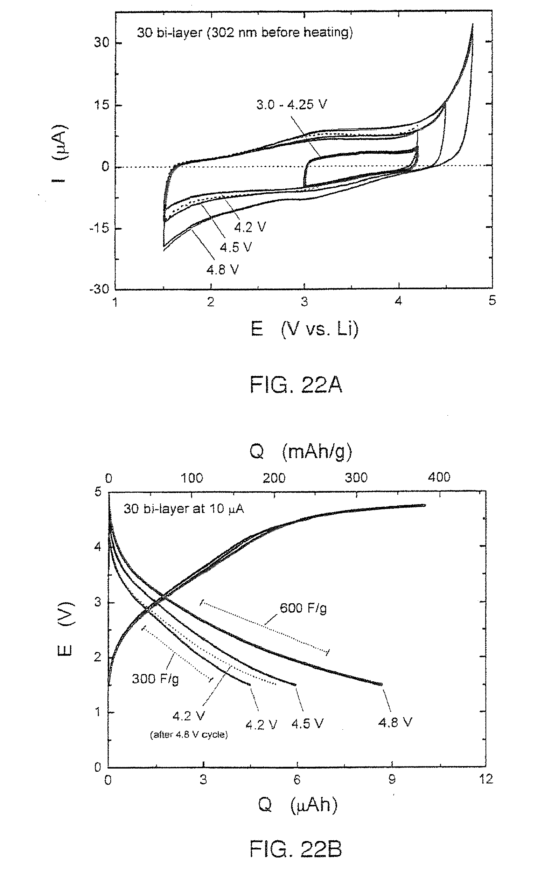

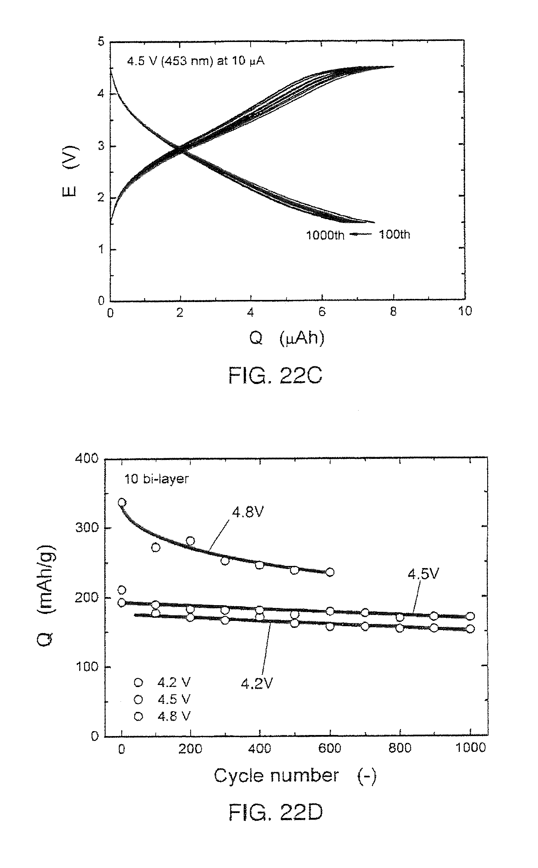

The capacitance (and/or capacity) obtained in the voltage of 3.00 - 4.25 V was considerably smaller than those observed in the wider potential range (FIGS. 18A-B). The dependence of the capacity on the potential range was further studied by slow-scan cyclic voltammetry at 1 mV/s, and the results are shown in FIG. 22A. When the anodic cut-off potential was fixed to 4.2 V and the cathodic cut-off potential was negatively shifted from 3.0 to 1.5 V, the current was roughly doubled during the anodic scanning in the range 3.0 - 4.2 V, whereas the cathodic current was almost identical in the same potential range. In addition, when the anodic cut-off potential was positively shifted from 4.2 to 4.5/4.8 V, a large gradient was observed above 4.2 V on the anodic current, and the cathodic current increased below 4 V for subsequent cycles. Not wishing to be bound by any theory, these results may support the idea that the large capacity of the carbon material originated, in part, from (a) electrochemical double layer charging, (b) a reduction process below 3 V vs. Li, and/or (c) an oxidation process above 4.2 V vs. Li. As an example of a reduction process that may have occurred in the system, surface oxygen on the MWNT might be reduced, and positively charged Li ions may be adsorbed, for example, to compensate for the charge of the oxygen. An example reaction is shown as:

C=O + Li+ + e- ↔ C-OLi (6)

where C=O indicates a carbonyl group at the basal plane of the MWNT. Carbonyl groups can be reduced with a sloping voltage profile to from 3.0 to 1.8 V, and reversibly oxidized. The discharging (reduction reaction) kinetics of Equation (6) are moderately fast. However the charging (oxidation) reaction may be relatively slower than the discharging process and may require larger polarization, causing energy loss.

Examples of oxidation processes that may have occurred in the system include the adsorption of PF₆⁻ anion to the amide group at the surface and/or intercalation of PF₆⁻ into MWNT layers. Both are Faradaic reactions. For the former case, the following reaction may have occurred:

C-(NH)PF₆-(C=O)-C + e- ↔ C-(NH)-(C=O)-C + PF₆- (7)

In addition, the basal plane of the MWNT may have been partly fractured by the methods discussed in relation to FIG. 21. These fractures may have enabled PF₆⁻ adsorption/intercalation to/from the fractured basal plane, and further increased the capacity of the samples. As can be seen in FIG. 22A, reaction of PF₆⁻ adsorption/intercalation is generally an energetically irreversible reaction.

FIG. 22B shows the charging potential dependence on the charge/discharge capacity at a constant current of 10 µA. When the charging potential was raised from 4.2 to 4.5/4.8 V, the capacity increased from 170 to 240/350 mAh/g, corresponding to 450/600 F/g. During the discharging process, two distinct reduction processes, PF₆⁻ desorption and Li⁺ adsorption into carbonyl group, may occur simultaneously. In addition, charging up to high voltage promotes further PF₆⁻ adsorption and/or intercalation, leading to higher capacity. Cycleability with different potential ranges was also examined, and the results are shown in FIGS. 22C-D.

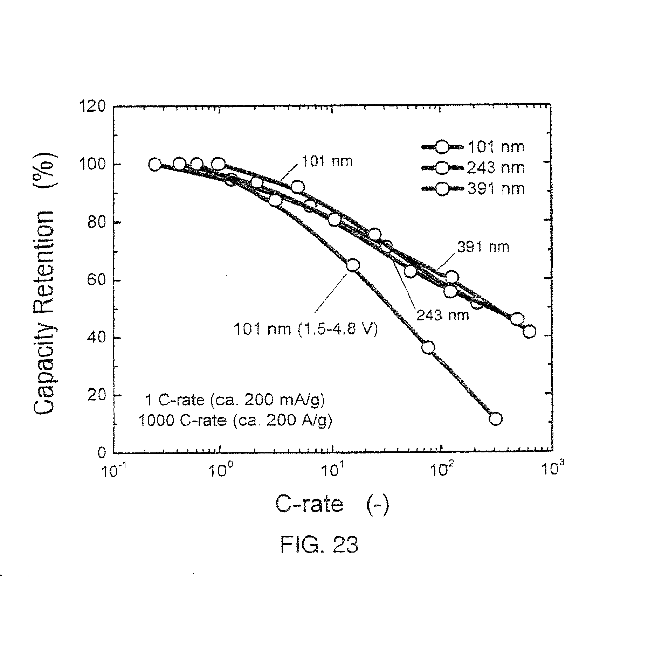

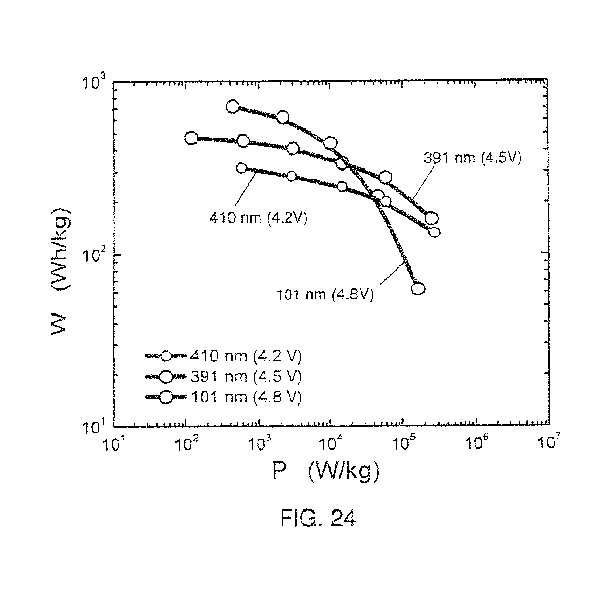

FIG. 23 illustrates the rate capability at 4.2, 4.5, and 4.8 V. FIG. 24 is a plot of specific energy vs. specific power (a Ragone plot) at 4.2, 4.5, and 4.8 V. One drawback of high-voltage, electrolyte decomposition, may be, in some cases, decreased cycleability of the device.

### EXAMPLE 2

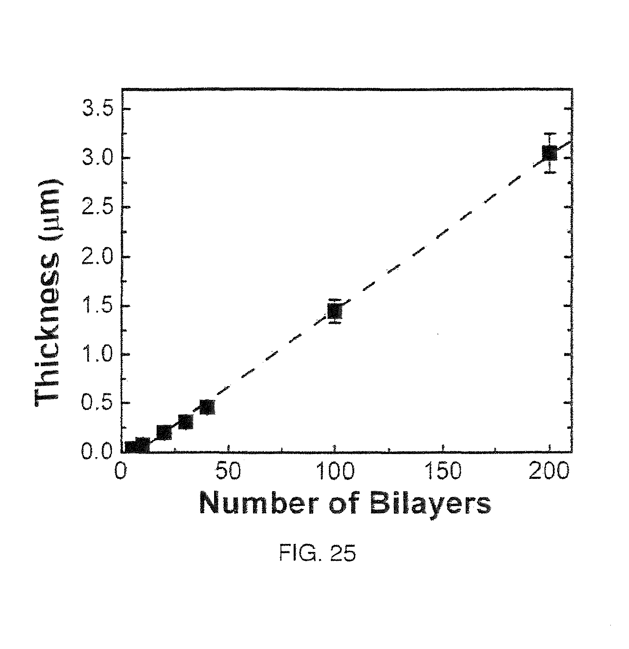

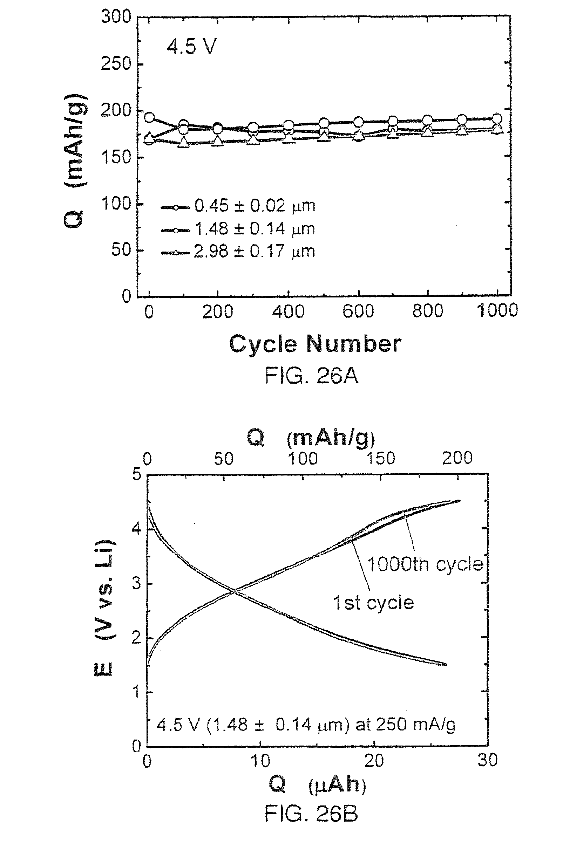

In this example, the performance of relatively thick (e.g., 1 micron and thicker) LBL-MWNT electrodes are described. The electrodes in this example were fabricated using similar techniques outlined in Example 1. The thickness of these electrodes as a function of the number of bilayers is shown in FIG. 25. As with the relatively thin electrode, the thickness varied linearly with the number ofbilayers. In addition, the relatively thick electrodes exhibited consistent performance over 1000 cycles, as illustrated in FIGS. 26A-26B.

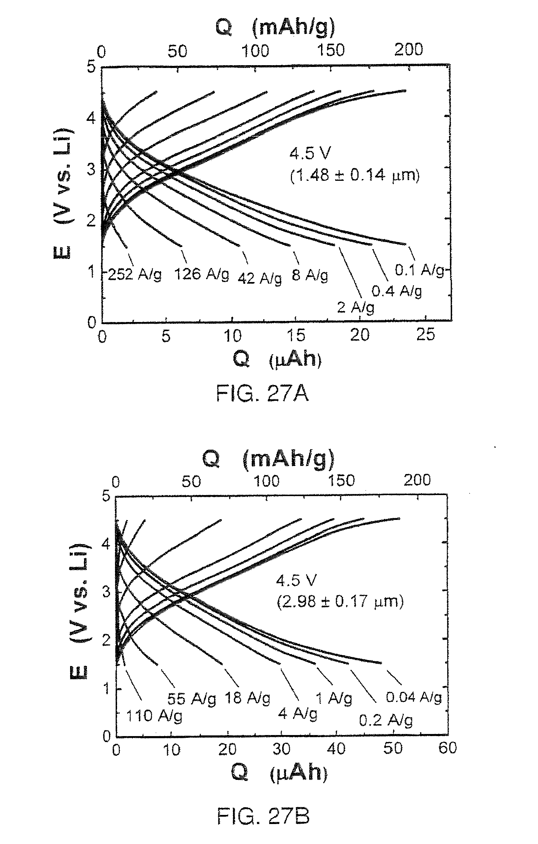

FIGS. 27A-27B include plots of charge and discharge voltages for 1.5 micron (A) and 3.0 micron (B) LBL-MWNT electrodes, respectively, obtained over a wide range of specific current densities over a voltage range of 1.5 V to 4.5 V, using Li as the counter-electrode. For electrodes with thicknesses greater than about 1.5 microns, the rate capability was slightly lower relative to thinner electrodes. However, it is believed that the observed thickness-dependent rate capability may not necessarily be characteristic of LBL-MWNT electrodes. Rather, the rate capability may have been limited by the slow kinetics of the lithium foil negative electrode (with had a much smaller electrode area relative to the LBL-MWNT electrodes) used in the two-electrode measurements. It should be noted that the background current from the cell apparatus and ITO coated glass was found to be negligible compared to that of the LBL-MWNT electrodes of about 0.2 micron thickness and greater.

### EXAMPLE 3

In this example, the performance of LBL-MWNT electrodes comprising a lithium-based compound are described. A fully lithiated Li₄Ti₅O₁₂ (LTO) composite electrode was also investigated as a counter-electrode to the LBL-MWNT electrodes. The LTO was prepared using a solid-state method with Li₂CO₃ (Alfa Aesar, 99.998%) and TiO₂ (Anataze, MTI Corporation, 99.99%, particle size:5-10 nm). Li₂CO₃ and TiO₂ were uniformly mixed (with a weight ratio of Li to Ti was 4.2/5.0), and the mixture was pre-heated at 600 °C for 1 hour in dry air. The product from the pre-heat-treatment was reground, pelletized, and then reheated up to 850 °C in dry air. To make the electrode, 80 wt% LTO was mixed with 10 wt% SUPER-P^{®} carbon black and 10 wt% polyvinylidene fluoride (PVdF) in N-methyl-2-pyrrolidone (NMP). The mixture was cast on an aluminum foil with a doctor blade, which and was dried in a vacuum oven at 60 °C for 2 hours and then at 110 °C for 12 hours. LTO electrodes with an area of 2.36 cm² (Average weight: 9.24 mg) were prelithiated using Li metal prior to electrochemical testing with MWNT electrodes. After preconditioning LTO by repeating lithiation and delithiation several times at 0.2 C (35 mA/g), lithiation was stopped at about 70% of the full capacity for use in LTO/MWNT cells.

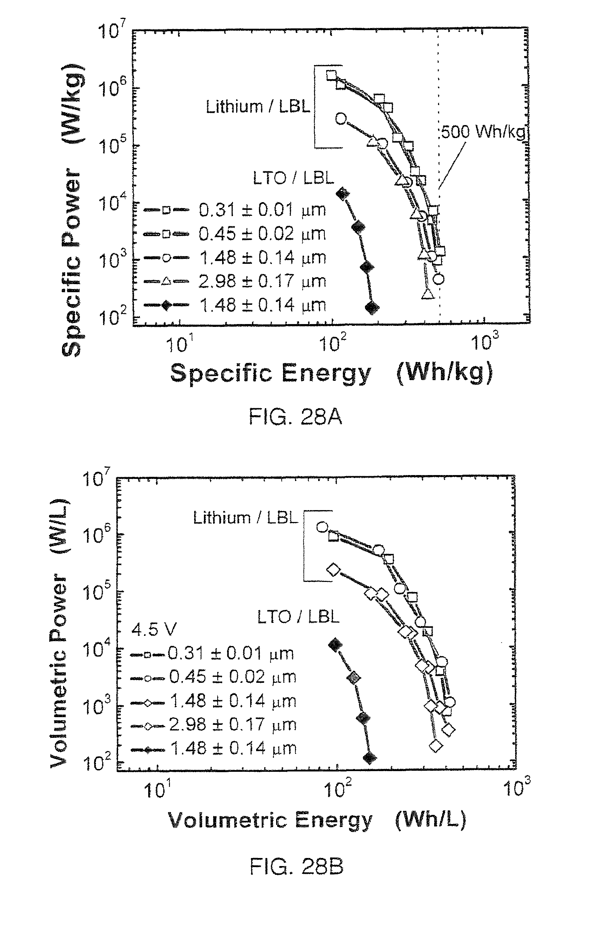

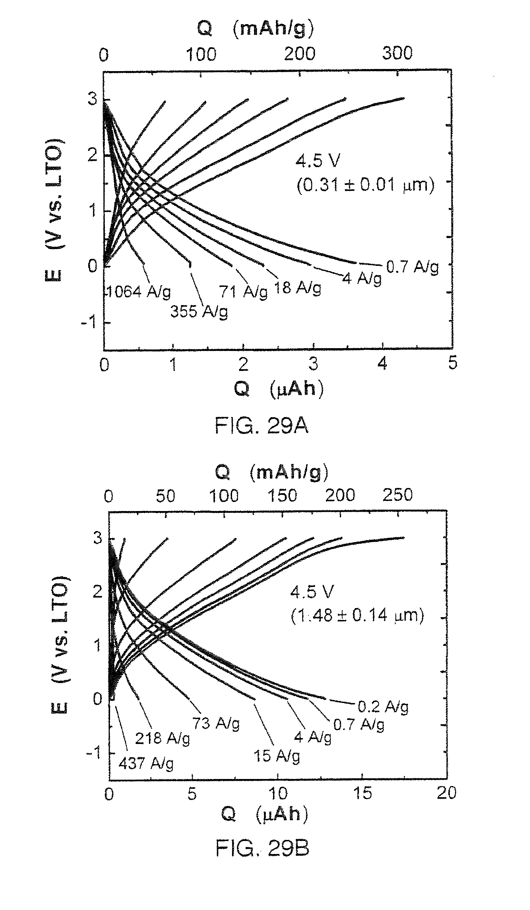

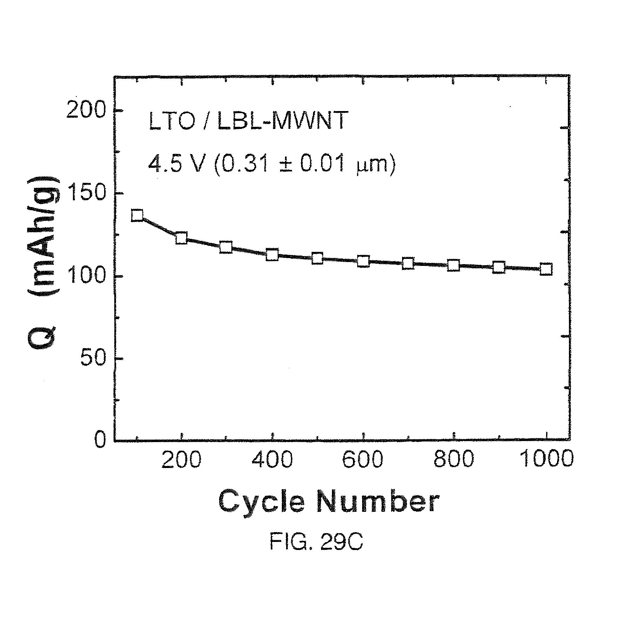

FIGS. 28A-28B include Ragone plots outlining the performance of the LBL-MWNT electrodes for lithium and LTO counter-electrodes. The volumetric energy density of LBL-MWNT electrodes, was about 2 to about 5 times smaller than those of the LiFePO₄ and LiCoO₂ electrodes due to a lower mass density (about 0.8 g/cm³ for LBL-MWNTs vs. about 4.0 g/cm³ for composite LiCoO₂ electrodes). Although the LTO/MWNT cells exhibited lower electrode gravimetric energy and power due to a lower cell voltage, the rate capability, gravimetric capacity and capacity retention were comparable to cells using the Li negative electrode, as illustrated in FIGS. 29A-29C. Using a well-known rule of thumb that relates packaged gravimetric energy density of practical devices to roughly 1/3 that of the electrode, it was estimated that LTO/MWNT storage devices could deliver about 50 Wh/kg.

While several embodiments of the present invention have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present invention. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings of the present invention is/are used. Those skilled in the art will recognize, or be able to ascertain using no more than routine experimentation, many equivalents to the specific embodiments of the invention described herein. It is, therefore, to be understood that the foregoing embodiments are presented by way of example only and that, within the scope of the appended claims and equivalents thereto, the invention may be practiced otherwise than as specifically described and claimed. The present invention is directed to each individual feature, system, article, material, kit, and/or method described herein. In addition, any combination of two or more such features, systems, articles, materials, kits, and/or methods, if such features, systems, articles, materials, kits, and/or methods are not mutually inconsistent, is included within the scope of the present invention.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Other elements may optionally be present other than the elements specifically identified by the "and/or" clause, whether related or unrelated to those elements specifically identified unless clearly indicated to the contrary. Thus, as a non-limiting example, a reference to "A and/or B," when used in conjunction with open-ended language such as "comprising" can refer, in one embodiment, to A without B (optionally including elements other than B); in another embodiment, to B without A (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e. "one or the other but not both") when preceded by terms of exclusivity, such as "either," "one of," "only one of," or "exactly one of." "Consisting essentially of," when used in the claims, shall have its ordinary meaning as used in the field of patent law.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, and at least one, optionally including more than one, B (and optionally including other elements); etc.

In the claims, as well as in the specification above, all transitional phrases such as "comprising," "including," "carrying," "having," "containing," "involving," "holding," and the like are to be understood to be open-ended, i.e., to mean including but not limited to. Only the transitional phrases "consisting of" and "consisting essentially of" shall be closed or semi-closed transitional phrases, respectively, as set forth in the United States Patent Office Manual of Patent Examining Procedures, Section 2111.03.

The following numbered items correspond to the claims in the international application WO 2010/019272 A2, from which the parent application of the present application resulted.
1. A method of forming an electrode comprising:
   providing a first fluid containing carbon-based nanostructures, the carbon-based nanostructures in the first fluid comprising positively-charged functional groups;
   providing a second fluid containing carbon-based nanostructures, the carbon-based nanostructures in the second fluid comprising negatively-charged functional groups;
   exposing a first portion of a surface of a substrate to the first fluid and depositing, proximate the first substrate surface portion, a first set of carbon-based nanostructures; and
   separately exposing a second portion of a surface of the substrate, which can be the same or different from the first substrate surface portion, to the second fluid and depositing, proximate the second substrate surface portion, a second set of carbon-based nanostructures.
2. The method of item 1, wherein the substrate comprises silicon.
3. The method of item 1, wherein the substrate comprises glass.
4. The method of item 1, wherein the substrate comprises a polymer.
5. The method of item 1, wherein the substrate is planar.
6. The method of item 1, wherein the substrate is non-planar.
7. The method of item 1, wherein the positively-charged functional groups comprise amines.
8. The method of item 7, wherein the amine comprises NH₂(CH₂)₂NH₂.
9. The method of item 1, wherein the negatively-charged functional groups comprise carboxyl groups.
10. The method of item 1, wherein the pH of the second fluid is about 2.5.
11. The method of item 1, wherein the pH of the second fluid is about 4.5.
12. The method of item 1, wherein the pH of the first fluid is about 2.5.
13. The method of item 1, wherein the pH of the first fluid is about 4.5.
14. The method of item 1, wherein the pH of the first fluid is between about 1 and about 7.
15. The method of item 1, wherein the pH of the first fluid is between about 2 and about 6.
16. The method of item 1, wherein the pH of the first fluid is between about 2.5 and about 4.5.
17. The method of item 1, wherein the pH of the second fluid is between about 1 and about 7.
18. The method of item 1, wherein the pH of the second fluid is between about 2 and about 6.
19. The method of item 1, wherein the pH of the second fluid is between about 2.5 and about 4.5.
20. The method of item 1, further comprising:
   subsequent to exposing the second portion of a surface of the substrate to the second fluid, separately exposing a third portion of a surface of the substrate, which can be the same or different from the first and/or second substrate surface portions, to the first fluid and depositing, proximate the third substrate surface portion, a third set of carbon-based nanostructures.
21. The method of item 1, further comprising:
   subsequent to exposing the second portion of a surface of the substrate to the second fluid, separately exposing a third portion of a surface of the substrate, which can be the same or different from the first and/or second substrate surface portions, to a third fluid containing carbon-based nanostructures, the carbon-based nanostructures in the third fluid comprising negatively-charged functional groups, and depositing, proximate the third substrate surface portion, a third set of carbon-based nanostructures.
22. The method of item 1, further comprising separating the carbon-based nanostructures from the surface of the substrate.
23. The method of item 16, wherein the separating step comprises exposing the assembly to water.
24. The method of item 1, wherein the first and/or second set of carbon-based nanostructures comprise carbon nanotubes.
25. The method of item 24, wherein the carbon nanotubes comprise multi-walled carbon nanotubes.
26. The method of item 2, wherein the first fluid comprises a first carrier fluid in which carbon-based nanostructures comprising positively-charged functional groups are suspended, and the second fluid comprises a second carrier fluid in which carbon-based nanostructures comprising negatively-charged functional groups are suspended.
27. The method of item 26, wherein the first and second carrier fluids are the same.
28. The method of item 26, wherein the first and second carrier fluids are different.
29. The method of item 1, wherein the carbon-based nanostructures have a length of about 10 microns.
30. The method of item 1, wherein the carbon-based nanostructures have a length between 1 and 5 microns.
31. A method comprising:
   using a device comprising an electrode comprising carbon-based nanostructures to achieve a capacitance at the electrode of at least about 300 Farads per cubic centimeter of the electrode.
32. The method of item 31, wherein the device is an energy storage device.
33. The method of item 32, wherein the energy storage device comprises a capacitor.
34. The method of item 32, wherein the energy storage device comprises a fuel cell.
35. The method of item 32, wherein the energy storage device comprises a photovoltaic cell.
36. The method of item 32, wherein the energy storage device comprises an electrochemical cell.
37. The method of item 31, wherein the carbon-based nanostructures comprise carbon nanotubes.
38. The method of item 31, wherein after alternatively charging and discharging the device 10 times, the device exhibits a capacitance of at least about 50% of the device's initial capacitance at the end of the tenth cycle.
39. The method of item 31, wherein after alternatively charging and discharging the device 100 times, the device exhibits a capacitance of at least about 50% of the device's initial capacitance at the end of the 100th cycle.
40. The method of item 31, wherein after alternatively charging and discharging the device 1000 times, the device exhibits a capacitance of at least about 50% of the device's initial capacitance at the end of the 1000th cycle.
41. The method of item 31, wherein the device is used to achieve a capacitance at the electrode of at least about 400 Farads per cubic centimeter of the electrode.
42. The method of item 31, wherein the device is used to achieve a capacitance at the electrode of at least about 450 Farads per cubic centimeter of the electrode.
43. The method of item 31, wherein the device further comprises lithium chemically adsorbed onto the surface of the carbon-based nanostructures.
44. The method of item 31, wherein the device is operated at a voltage of between about 0 and about 8 volts.
45. A method comprising:
   using a device comprising an electrode comprising carbon-based nanostructures to achieve an energy density at the electrode of at least about 400 Watt-hours per liter of the electrode.
46. The method of item 45, wherein the device provides power at the electrode at a rate of at least about 1 kW per kilogram of the electrode.
47. The method of item 45, wherein the device comprises an energy storage device.
48. The method of item 47, wherein the energy storage device comprises a capacitor.
49. The method of item 47, wherein the energy storage device comprises a fuel cell.
50. The method of item 47, wherein the energy storage device comprises a photovoltaic cell.
51. The method of item 47, wherein the energy storage device comprises an electrochemical cell.
52. The method of item 45, wherein the carbon-based nanostructures comprise carbon nanotubes.
53. The method of item 45, wherein after alternatively charging and discharging the device 10 times, the device exhibits an energy density of at least about 50% of the device's initial energy density at the end of the tenth cycle.
54. The method of item 45, wherein after alternatively charging and discharging the device 100 times, the device exhibits an energy density of at least about 50% of the device's initial energy density at the end of the 100th cycle.
55. The method of item 45, wherein after alternatively charging and discharging the device 1000 times, the device exhibits an energy density of at least about 50% of the device's initial energy density at the end of the 1000th cycle.
56. The method of item 45, wherein the device is used to achieve an energy density at the electrode of at least about 500 Watt-hours per liter of the electrode.
57. The method of item 45, wherein the device is used to achieve an energy density at the electrode of at least about 600 Watt-hours per liter of the electrode.
58. The method of item 45, wherein the device is used to achieve an energy density at the electrode of at least about 700 Watt-hours per liter of the electrode.
59. The method of item 45, wherein the device is used to achieve an energy density at the electrode of at least about 750 Watt-hours per liter of the electrode.
60. The method of item 45, wherein the device further comprises lithium chemically adsorbed onto the surface of the carbon-based nanostructures.
61. The method of item 45, wherein the electrode is capable of transmitting at least about 15% of incident visible light within the range of about 500 to about 600 nm.
62. The method of item 45, wherein the electrode is capable of transmitting at least about 20% of incident visible light within the range of about 500 to about 600 nm.
63. The method of item 45, wherein the electrode is capable of transmitting at least about 30% of incident visible light within the range of about 500 to about 600 nm.
64. The method of item 45, wherein the device further comprises a second electrode comprising carbon-based nanostructures.
65. The method of item 64, wherein the first electrode is a negative electrode and the second electrode is a positive electrode.
66. The method of item 64, wherein the first electrode is a positive electrode and the second electrode is a negative electrode.
67. The method of item 45, wherein the device is operated at a voltage of between about 0 and about 8 volts.
68. An electrode with a thickness of at least about 10 nanometers comprising carbon-based nanostructures and defining a composition volume, each of the carbon-based nanostructures defining a nanostructure volume, wherein the total of the volumes of the nanostructures defines at least about 60% of the composition volume.
69. The electrode of item 68, wherein the composition is substantially free of binder.
70. The electrode of item 68, wherein the composition is part of an energy storage device.
71. The electrode of item 70, wherein the energy storage device comprises a capacitor.
72. The electrode of item 70, wherein the energy storage device comprises a fuel cell.
73. The electrode of item 70, wherein the energy storage device comprises a photovoltaic cell.
74. The electrode of item 70, wherein the energy storage device comprises an electrochemical cell.
75. The electrode of item 68, wherein carbon defines at least about 50% of the mass of the solids in the composition.
76. The electrode of item 68, wherein the carbon-based nanostructures comprise carbon nanotubes.
77. The electrode of item 68, wherein the composition is fabricated using a layer-by-layer technique.
78. The electrode of item 68, wherein the composition further comprises metal atoms.
79. The electrode of item 68, wherein the total of the volumes of the nanostructures defines at least about 65% of the composition volume.
80. The electrode of item 68, wherein the total of the volumes of the nanostructures defines at least about 70% of the composition volume.
81. The electrode of item 68, wherein the total of the volumes of the nanostructures defines at least about 75% of the composition volume.
82. The electrode of item 68, wherein the total of the volumes of the nanostructures defines at least about 80% of the composition volume.
83. The electrode of item 68, wherein the total of the volumes of the nanostructures defines at least about 85% of the composition volume.
84. The electrode of item 68, wherein the total of the volumes of the nanostructures defines between about 60% and about 90% of the composition volume.
85. The electrode of item 68, wherein the composition is capable of transmitting at least about 15% of incident visible light within the range of about 500 to about 600 nm.
86. The electrode of item 68, wherein the composition is capable of transmitting at least about 20% of incident visible light within the range of about 500 to about 600 nm.
87. The electrode of item 68, wherein the composition is capable of transmitting at least about 30% of incident visible light within the range of about 500 to about 600 nm.
88. A device comprising:
   an electrode comprising carbon-based nanostructures capable of achieving a capacitance at the electrode of at least about 300 Farads per cubic centimeter of the electrode.
89. The device of item 88, wherein the electrode is substantially free of binder.
90. The device of item 88, wherein the device is an energy storage device.
91. The device of item 90, wherein the energy storage device comprises a capacitor.
92. The device of item 90, wherein the energy storage device comprises a fuel cell.
93. The device of item 90, wherein the energy storage device comprises a photovoltaic cell.
94. The device of item 90, wherein the energy storage device comprises an electrochemical cell.
95. The device of item 88, wherein carbon defines at least about 50% of the mass of the solids in the assembly.
96. The device of item 88, wherein the carbon-based nanostructures comprise carbon nanotubes.
97. The device of item 88, wherein the electrode is fabricated using a layer-by-layer technique.
98. The device of item 88, further comprising an aqueous electrolyte.
99. The device of item 88, further comprising a non-aqueous electrolyte.
100. The device of item 88, wherein the electrode comprises a thin film.
101. The device of item 100, wherein the thin film is at least about 1 micron thick.
102. The device of item 100, wherein the thin film is at least about 10 microns thick.
103. The device of item 100, wherein the film is less than about 100 nanometers thick.
104. The device of item 88, wherein after alternatively charging and discharging the device 10 times, the device exhibits a capacitance of at least about 50% of the device's initial capacitance at the end of the tenth cycle.
105. The device of item 88, wherein after alternatively charging and discharging the device 100 times, the device exhibits a capacitance of at least about 50% of the device's initial capacitance at the end of the 100th cycle.
106. The device of item 88, wherein after alternatively charging and discharging the device 1000 times, the device exhibits a capacitance of at least about 50% of the device's initial capacitance at the end of the 1000th cycle.
107. The device of item 88, wherein the device is capable of achieving a capacitance at the electrode of at least about 400 Farads per cubic centimeter of the electrode.
108. The device of item 88, wherein the device is capable of achieving a capacitance at the electrode of at least about 450 Farads per cubic centimeter of the electrode.
109. The device of item 88, further comprising lithium chemically adsorbed onto the surface of the carbon-based nanostructures.
110. The device of item 88, wherein the electrode is capable of transmitting at least about 15% of incident visible light within the range of about 500 to about 600 nm.
111. The device of item 88, wherein the electrode is capable of transmitting at least about 20% of incident visible light within the range of about 500 to about 600 nm.
112. The device of item 88, wherein the electrode is capable of transmitting at least about 30% of incident visible light within the range of about 500 to about 600 nm.
113. The device of item 88, wherein the device further comprises a second electrode comprising carbon-based nanostructures.
114. The device of item 113, wherein the first electrode is a negative electrode and the second electrode is a positive electrode.
115. The device of item 113, wherein the first electrode is a positive electrode and the second electrode is a negative electrode.
116. A device comprising:
   an electrode comprising carbon-based nanostructures capable of achieving an energy density at the electrode of at least about 400 Watt-hours per liter of the electrode.
117. The device of item 116, wherein the energy density is achieved while the device provides power at the electrode at a rate of at least about 1 kW per kilogram of the electrode.
118. The device of item 116, wherein the electrode is substantially free of binder.
119. The device of item 116, wherein the device is an energy storage device.
120. The device of item 119, wherein the energy storage device comprises a capacitor.
121. The device of item 119, wherein the energy storage device comprises a fuel cell.
122. The device of item 119, wherein the energy storage device comprises a photovoltaic cell.
123. The device of item 119, wherein the energy storage device comprises an electrochemical cell.
124. The device of item 116, wherein carbon defines at least about 50% of the mass of the solids in the assembly.
125. The device of item 116, wherein the carbon-based nanostructures comprise carbon nanotubes.
126. The device of item 116, wherein the electrode is fabricated using a layer-by-layer technique.
127. The device of item 116, further comprising an aqueous electrolyte.
128. The device of item 116, further comprising a non-aqueous electrolyte.
129. The device of item 116, wherein the electrode comprises a thin film.
130. The device of item 129, wherein the thin film is at least about 1 micron thick.
131. The device of item 129, wherein the thin film is at least about 10 microns thick.
132. The device of item 129, wherein the film is less than about 100 nanometers thick.
133. The device of item 116, wherein after alternatively charging and discharging the device 10 times, the device exhibits an energy density of at least about 50% of the device's initial energy density at the end of the tenth cycle.
134. The device of item 116, wherein after alternatively charging and discharging the device 100 times, the device exhibits an energy density of at least about 50% of the device's initial energy density at the end of the 100th cycle.
135. The device of item 116, wherein after alternatively charging and discharging the device 1000 times, the device exhibits an energy density of at least about 50% of the device's initial energy density at the end of the 1000th cycle.
136. The device of item 116, wherein the device is capable of achieving an energy density at the electrode of at least about 500 Watt-hours per liter of the electrode.
137. The device of item 116, wherein the device is capable of achieving an energy density at the electrode of at least about 600 Watt-hours per liter of the electrode.
138. The device of item 116, wherein the device is capable of achieving an energy density at the electrode of at least about 700 Watt-hours per liter of the electrode.
139. The device of item 116, wherein the device is capable of achieving an energy density at the electrode of at least about 750 Watt-hours per liter of the electrode.
140. The device of item 116, further comprising lithium chemically adsorbed onto the surface of the carbon-based nanostructures.
141. The device of item 116, wherein the electrode is capable of transmitting at least about 15% of incident visible light within the range of about 500 to about 600 nm.
142. The device of item 116, wherein the electrode is capable of transmitting at least about 20% of incident visible light within the range of about 500 to about 600 nm.
143. The device of item 116, wherein the electrode is capable of transmitting at least about 30% of incident visible light within the range of about 500 to about 600 nm.
144. The device of item 116, wherein the device further comprises a second electrode comprising carbon-based nanostructures.
145. A device comprising:
   an electrode comprising carbon-based nanostructures capable of achieving a capacitance at the electrode of at least about 400 Farads per gram of the electrode.
146. The device of item 145, wherein the device is capable of achieving a capacitance at the electrode of at least about 500 Farads per gram of the electrode.
147. The device of item 145, wherein the device is capable of achieving a capacitance at the electrode of at least about 550 Farads per gram of the electrode.
148. The device of item 145, wherein after alternatively charging and discharging the device 10 times, the device exhibits a capacitance of at least about 50% of the device's initial capacitance at the end of the tenth cycle.
149. The device of item 145, wherein after alternatively charging and discharging the device 100 times, the device exhibits a capacitance of at least about 50% of the device's initial capacitance at the end of the 100th cycle.
150. The device of item 145, wherein after alternatively charging and discharging the device 1000 times, the device exhibits a capacitance of at least about 50% of the device's initial capacitance at the end of the 1000th cycle.
151. The device of item 145, wherein the electrode is substantially free of binder.
152. The device of item 145, wherein the device further comprises a second electrode comprising carbon-based nanostructures.
153. A device comprising:
   an electrode comprising carbon-based nanostructures capable of achieving a specific energy at the electrode of at least about 500 Watt-hours per kilogram of the electrode.
154. The device of item 153, wherein the energy density is achieved while the device provides power at the electrode at a rate of at least about 1 kW per kilogram of the electrode.
155. The device of item 153, wherein the device is capable of achieving a specific energy at the electrode of at least about 600 Watt-hours per kilogram of the electrode.
156. The device of item 153, wherein the device is capable of achieving a specific energy at the electrode of at least about 700 Watt-hours per kilogram of the electrode.
157. The device of item 153, wherein the device is capable of achieving a specific energy at the electrode of at least about 800 Watt-hours per kilogram of the electrode.
158. The device of item 153, wherein the device is capable of achieving a specific energy at the electrode of at least about 850 Watt-hours per kilogram of the electrode.
159. The device of item 153, wherein the device is capable of achieving a specific energy at the electrode of at least about 900 Watt-hours per kilogram of the electrode.
160. The device of item 153, wherein after alternatively charging and discharging the device 10 times, the device exhibits a specific energy of at least about 50% of the device's initial specific energy at the end of the tenth cycle.
161. The device of item 153, wherein after alternatively charging and discharging the device 100 times, the device exhibits a specific energy of at least about 50% of the device's initial specific energy at the end of the 100th cycle.
162. The device of item 153, wherein after alternatively charging and discharging the device 1000 times, the device exhibits a specific energy of at least about 50% of the device's initial specific energy at the end of the 1000th cycle.
163. The device of item 153, wherein the electrode is substantially free of binder.
164. The device of item 153, wherein the device further comprises a second electrode comprising carbon-based nanostructures.
165. A method comprising:
   using a device comprising an electrode comprising carbon-based nanostructures to achieve a capacitance at the electrode of at least about 400 Farads per gram of the electrode.
166. The method of item 165, wherein the device is operated at a voltage of between about 1 and about 8 volts.
167. A method comprising:
   using a device comprising an electrode comprising carbon-based nanostructures to achieve a specific energy at the electrode of at least about 500 Watt-hours per kilogram of the electrode.
168. The method of item 167, wherein the specific energy is achieved while the device is operated at a voltage of between about 1 and about 8 volts.
169. The method of item 167, wherein the specific energy is achieved while the device provides power at the electrode at a rate of at least about 1 kW per kilogram of the electrode.
170. A device comprising an electrode capable of converting at least about 60% of energy input into the device during a charging step to energy stored within the device, the charging step performed so as to charge the device to a capacity of at least about 50% within 1 second.
171. The device of item 170, wherein the device is capable of converting at least 70% of the energy input into the device.
172. The device of item 170, wherein the device is capable of converting at least 75% of the energy input into the device.
173. The device of item 170, wherein the device is capable of converting at least 80% of the energy input into the device.
174. The device of item 170, wherein the electrode comprises carbon-based nanostructures.
175. A device comprising an electrode capable of converting at least about 60% of the energy stored after a charging step to electricity during a discharge step, the discharge step performed such that at least about 50% of the capacity of the device is discharged within 1 second.
176. The device of item 175, wherein the device is capable of converting at least about 70% of the energy stored after a charging step.
177. The device of item 175, wherein the device is capable of converting at least about 75% of the energy stored after a charging step.
178. The device of item 175, wherein the device is capable of converting at least about 80% of the energy stored after a charging step.
179. A device comprising an electrode capable of converting at least about 60% of energy input into the device during a charging step to energy stored within the device, the charging step performed at a rate of at least about 1 kW per kilogram of the electrode.
180. A device comprising an electrode capable of converting at least about 60% of the energy stored after a charging step to electricity during a discharge step, the discharge step performed at a rate of at least about 1 kW per kilogram of the electrode.

## Claims

1. An electrode with a thickness of at least about 10 nanometers comprising carbon-based nanostructures, and defining a composition volume, wherein:
each of the carbon-based nanostructures defines a nanostructure volume,
the total of the volumes of the nanostructures defines at least about 60% of the composition volume, and
at least a portion of the carbon-based nanostructures comprise carbon-oxygen bonds wherein oxygen defines at least about 10% of the mass of the solids in the composition.

2. The electrode of claim 1, wherein the oxygen is configured to interact with an ion.

3. The electrode of claim 2, wherein the oxygen is configured to participate in redox reactions with an electrochemically active ion.

4. The electrode of any one of claims 1-3, wherein the oxygen is configured to participate in redox reactions with Li⁺.

5. The electrode of any one of claims 1-4, wherein the electrode is a positive electrode.

6. The electrode of any one of claims 1-5, wherein the composition is substantially free of binder.

7. The electrode of any one of claims 1-6, wherein the composition comprises carbon-based nanostructures comprising positively-charged functional groups.

8. The electrode of any one of claims 1-7, wherein the composition comprises carbon-based nanostructures comprising negatively-charged functional groups.

9. The electrode of any one of claims 1-8, wherein carbon defines at least about 50% of the mass of the solids in the composition.

10. The electrode of any one of claims 1-9, wherein oxygen defines at least about 15%, at least about 25%, or at least about 40% of the mass of the solids in the composition.

11. The electrode of any one of claims 1-10, wherein the carbon-based nanostructures comprise carbon nanotubes.

12. The electrode of any one of claims 1-11, wherein the electrode is part of a device capable of achieving a specific energy at the electrode of at least about 500 Watt hours per kilogram of the electrode and/or an energy density at the electrode of at least 400 Watt hours per liter of the electrode.

13. The electrode of any one of claims 1-12, wherein the electrode is part of a device capable of providing power at the electrode at a rate of at least 100 W per kilogram of the electrode and/or at a rate of at least 80 W per liter of electrode.

14. An electrochemical cell comprising the electrode of any one of claims 1-13.

15. A method of operating an electrochemical cell comprising the electrode of any one of claims 1-14, comprising charging and/or discharging the electrochemical cell such that the oxygen participates in redox reactions with an ion.
